# EUROPEAN PATENT APPLICATION

(11) **EP 4 310 664 A1**
(43) Date of publication of application: **24.01.2024**
(21) Application number: 22790889.4
(22) Date of filing: 11.04.2022
(51) Int. Cl.: G06F 3/16, G11C 7/16, G06F 9/445

(54) **AUDIO OUTPUT METHOD, MEDIA FILE RECORDING METHOD, AND ELECTRONIC DEVICE**

(30) Priority: 21.04.2021 CN 202110430850
(71) Applicant: Huawei Technologies Co., Ltd., Shenzhen, Guangdong 518129 (CN)
(72) Inventor: WANG, Aofei, Shenzhen, Guangdong 518129 (CN); YU, Fei, Shenzhen, Guangdong 518129 (CN); FAN, Yajun, Shenzhen, Guangdong 518129 (CN)
(74) Representative: Grünecker Patent- und Rechtsanwälte PartG mbB
(86) International application number: PCT/CN2022/086067
(87) International publication number: WO 2022/222780

(57) **Abstract**

An audio output method, a media file recording method, an electronic device, and a computer-readable storage medium are provided. The audio output method is applied to an electronic device, and includes: receiving audio output requests from M audio applications on the electronic device; and selecting N target applications from the M audio applications, and outputting audio data of the N target applications, where M is greater than N. In this application, a quantity of target applications is limited, so that a case in which audio of a plurality of applications interferes with each other in a conventional technology can be improved. In addition, a plurality of target applications (provided that a quantity of target applications does not exceed N) are allowed to output audio at the same time in this application. Therefore, a requirement of a user for listening to a plurality of pieces of audio at the same time can be met.

## Description

This application claims priority to Chinese Patent Application No. 202110430850.5, filed with the China National Intellectual Property Administration on April 21, 2021 and entitled "AUDIO OUTPUT METHOD, MEDIA FILE RECORDING METHOD, AND ELECTRONIC DEVICE", which is incorporated herein by reference in its entirety.

### TECHNICAL FIELD

This application relates to the field of electronic technologies, and in particular, to an audio output method, a media file recording method, an electronic device, and a computer-readable storage medium.

### BACKGROUND

Various audio applications such as a music application, a navigation application, and a conference application may be installed on an electronic device (for example, a mobile phone). In some electronic device, once an audio play request is generated in an application, the electronic device responds to the request, and play audio corresponding to the application. In this way, when a plurality of applications request to output audio at the same time, sounds from the plurality of applications are mixed together and interfere with each other, affecting user experience.

Some other electronic devices use an audio focus mechanism. According to the audio focus mechanism, a last application that sends an audio output request outputs audio, which has low flexibility of audio output.

### SUMMARY

Some implementations of this application provide an audio output method, a media file recording method, an electronic device, and a computer-readable storage medium. The following describes this application from a plurality of aspects. For implementations and beneficial effects of the following plurality of aspects, refer to each other.

According to a first aspect, an implementation of this application provides an audio output method, applied to an electronic device. The method includes: receiving audio output requests from M audio applications on the electronic device (for example, an operating system of the electronic device receives audio output requests from the M audio applications on the electronic device); selecting N target applications from the M audio applications (for example, the operating system of the electronic device selects N target applications from the M audio applications), and outputting audio data of the N target applications; where M is greater than N.

In other words, in this implementation of this application, a maximum quantity of applications (referred to as "target applications" in this specification) that output audio at a same moment is limited. When the quantity M of applications (referred to as "candidate applications" in this specification) that request to output audio is greater than the threshold N, the electronic device filters the candidate applications, to limit the quantity of target applications to N. By limiting the quantity of target applications, this implementation of this application can improve a case in which audio of a plurality of applications interferes with each other in a conventional technology.

In addition, in an audio focus mechanism in the conventional technology, a last application that sends an audio output request is determined as a target application that outputs audio. In an implementation of this application, the N target applications may be selected from the M candidate applications based on any filtering condition (for example, a filtering condition specified by a user). Therefore, compared with the audio focus mechanism in the conventional technology, in this implementation of this application, a target application that outputs audio can be determined in a more flexible manner, thereby improving user experience.

In some implementations, N is a positive integer greater than 2.

According to this implementation of this application, a plurality of target applications (provided that a quantity of target applications does not exceed N (N≥2)) are allowed to output audio at the same time. Therefore, a requirement of a user for listening to a plurality of pieces of audio at the same time can be met.

In some implementations, the selecting N target applications from the M audio applications includes: selecting the N target applications from the M audio applications based on a current working scenario of the electronic device; selecting the N target applications from the M audio applications based on preset application priority information; or selecting the N target applications from the M audio applications based on a selection operation performed by a user on the M audio applications.

According to this implementation of this application, a target device is determined based on the current working scenario of the electronic device, application priorities, or real-time user designation, so that a user requirement can be better met, and user experience can be improved.

In some implementations, the selecting the N target applications from the M audio applications based on a current working scenario of the electronic device includes: determining the current working scenario of the electronic device; determining a scenario-based application from the M audio applications based on the current working scenario, where the scenario-based application is an application required in the current working scenario; and determining the N target applications based on a determining result of the scenario-based application, where the N target applications include at least the scenario-based application.

According to this implementation of this application, the N target applications include at least an application (namely, the scenario-based application) required in the current working scenario, so that audio output by the electronic device better matches the current working scenario, thereby improving user experience.

In some implementations, the determining the N target applications based on a determining result of the scenario-based application includes: determining a priority of each of the M audio applications based on a determining result of the scenario-based application, where a priority of the scenario-based application is higher than a priority of another application in the M audio applications; and determining N audio applications with highest priorities as the N target applications based on an order of priorities of the M audio applications, so that the N target applications include at least the scenario-based application.

In some implementations, the determining the current working scenario of the electronic device includes: determining the current working scenario based on another electronic device that is communicatively connected to the electronic device; determining the current working scenario based on an application currently running on the electronic device; determining the current working scenario based on measurement data of a specific sensor on the electronic device, where the specific sensor is configured to measure a displacement, a speed, and/or acceleration data of the electronic device; or determining the current working scenario based on a scenario specifying operation of the user.

In some implementations, the current working scenario of the electronic device includes an in-vehicle scenario, a home scenario, a conference scenario, a motion scenario, or a high-speed rail travel scenario.

In some implementations, the electronic device includes a plurality of pieces of volume control information corresponding to the N target applications, and each of the N target applications corresponds to one of the plurality of pieces of volume control information; and the outputting audio data of the N target applications includes: determining volume of the target application based on volume control information corresponding to the target application; and outputting audio data of the target application at the volume.

In some implementations, the electronic device includes N pieces of volume control information, and the N target applications are in a one-to-one correspondence with the N pieces of volume control information. Therefore, volume of each target application can be independently controlled.

In some implementations, the electronic device includes a plurality of pieces of volume control information corresponding to the N target applications, and each of the plurality of pieces of volume control information can be determined based on a user input.

According to this implementation of this application, the user can adjust the volume of each application as needed, to improve user experience.

In some implementations, the outputting audio data of the N target applications includes: playing the audio data of the N target applications by using a plurality of audio playback devices, where the audio playback devices include the electronic device and/or a device other than the electronic device.

In some implementations, the playing the audio data of the N target applications by using a plurality of audio playback devices includes: determining an audio playback device corresponding to each of the N target applications, and playing the audio data of the N target applications based on a determining result of the audio playback device; and the determining an audio playback device corresponding to each of the N target applications includes: determining, based on preset device priority information, an audio playback device corresponding to the target application; or determining, based on a quantity of times the target application is played on each of the audio playback devices, an audio playback device corresponding to the target application.

In some implementations, the M audio applications are applications other than a system phone application.

In some implementations, N is determined by the electronic device based on a quantity of audio playback devices that are currently communicatively connected to the electronic device.

According to a second aspect, an implementation of this application provides a media file recording method, applied to an electronic device. The method includes: receiving a first input when the electronic device outputs audio data of a plurality of audio applications, where the first input is used to select one or more target applications from the plurality of audio applications; and recording a first media file. The recording a first media file includes: recording audio data of the one or more target applications, to generate the first media file.

According to this implementation of this application, when the electronic device outputs audio of a plurality of audio applications (referred to as "candidate applications"), the electronic device records only audio of a selected application (referred to as a "target application"), and does not record audio of a candidate application other than the target application. This meets diversified requirements of a user.

In some implementations, a quantity of target applications is less than a quantity of audio applications that currently output audio.

In some implementations, when the electronic device outputs the audio data of the plurality of audio applications, the electronic device outputs video data of a first video application; and the recording a first media file includes: recording audio data of the one or more target applications, and recording the video data of the first video application, to generate the first media file.

According to this implementation of this application, when recording a video, the user may select a video data source and an audio data source. This meets diversified requirements of the user.

According to a third aspect, an implementation of this application provides an electronic device, including: a memory, configured to store instructions executed by one or more processors of the electronic device; and a processor, where when the processor executes the instructions in the memory, the electronic device is enabled to perform the audio output method provided in any one of the implementations in the first aspect of this application, or perform the media file recording method provided in any one of the implementations in the second aspect of this application.

According to a fourth aspect, an implementation of this application provides a computer-readable storage medium, where the computer-readable storage medium stores instructions. When the instructions are executed on a computer, the computer is enabled to perform the audio output method provided in any one of the implementations in the first aspect of this application, or perform the media file recording method provided in any one of the implementations in the second aspect of this application.

### BRIEF DESCRIPTION OF DRAWINGS

FIG. 1 shows an example application scenario 1 of an audio output method according to an embodiment of this application;
FIG. 2 is a diagram of an example structure of a focus queue in an audio focus mechanism;
FIG. 3 shows an example scenario in which a candidate application on an electronic device sends an audio output request according to an embodiment of this application;
FIG. 4a is an example flowchart 1 of a method for selecting a target application according to an embodiment of this application;
FIG. 4b is a diagram of an example interface for specifying a current working scenario according to an embodiment of this application;
FIG. 5a is a diagram of an example interface for specifying a key application according to an embodiment of this application;
FIG. 5b is an example flowchart 2 of a method for selecting a target application according to an embodiment of this application;
FIG. 6a is a diagram of an example interface 1 for specifying a target application according to an embodiment of this application;
FIG. 6b is a diagram of an example interface 2 for specifying a target application according to an embodiment of this application;
FIG. 7a is a schematic diagram 1 of a focus queue according to an embodiment of this application;
FIG. 7b is a schematic diagram 2 of a focus queue according to an embodiment of this application;
FIG. 7c is a schematic diagram 3 of a focus queue according to an embodiment of this application;
FIG. 8 is an example flowchart of an audio output method according to an embodiment of this application;
FIG. 9 is an example flowchart 1 of outputting audio of a target application by an electronic device according to an embodiment of this application;
FIG. 10a is a schematic diagram 1 of a volume adjustment interface according to an embodiment of this application;
FIG. 10b is a schematic diagram 2 of a volume adjustment interface according to an embodiment of this application;
FIG. 11 shows an example application scenario 2 of an audio output method according to an embodiment of this application;
FIG. 12a is an example flowchart 2 of outputting audio of a target application by an electronic device according to an embodiment of this application;
FIG. 12b is a diagram 1 of an interface for specifying a preferred playback device according to an embodiment of this application;
FIG. 12c is a diagram 2 of an interface for specifying a preferred playback device according to an embodiment of this application;
FIG. 13 shows an example application scenario 1 of a media file recording method according to an embodiment of this application;
FIG. 14 is an example flowchart of a media file recording method according to an embodiment of this application;
FIG. 15 is a diagram of an example interface for selecting an audio source of a media file according to an embodiment of this application;
FIG. 16 shows an example application scenario 2 of a media file recording method according to an embodiment of this application;
FIG. 17 is a schematic diagram of a structure of an electronic device according to an embodiment of this application;
FIG. 18 is a block diagram of a control device according to an implementation of this application; and
FIG. 19 is a schematic diagram of a structure of a system on chip (System on Chip, SoC) according to an implementation of this application.

### DESCRIPTION OF EMBODIMENTS

The following describes specific implementations of this application in detail with reference to accompanying drawings.

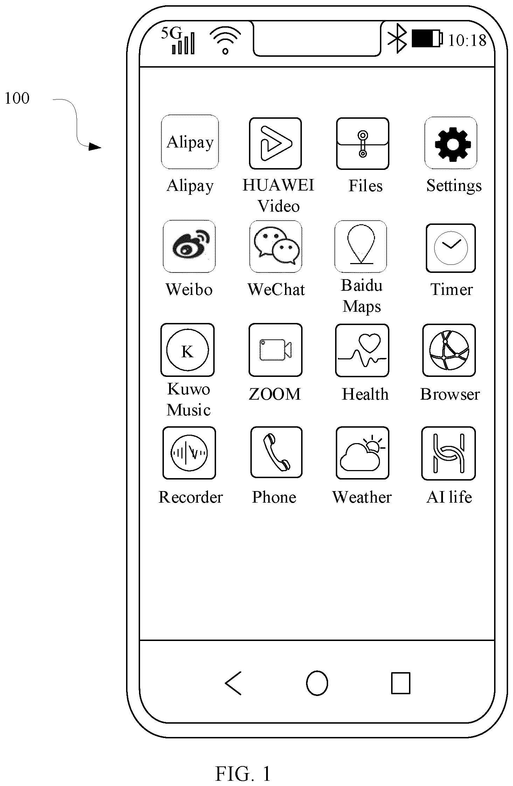

FIG. 1 shows an application scenario according to an implementation of this application. In FIG. 1, a plurality of audio applications are installed on an electronic device 100 (specifically, a mobile phone), and each audio application may output audio data (referred to as "audio") of different content. For example, Kuwo Music^{™} may output audio of a music program, ZOOM^{™} may output conference voice, Dragonfly FM^{™} may output audio of a radio program, Baidu Maps^{™} may output navigation voice, and so on.

In some electronic device, once an audio output request (referred to as "request") is generated in an application, the electronic device responds to the request, and play audio corresponding to the application. For example, after a user starts Kuwo Music and Baidu Maps, the electronic device plays a song and a navigation voice. In this case, if the user answers an incoming call on the electronic device, the electronic device plays a call voice at the same time. Then, if a timer set on the electronic device expires, the electronic device plays a prompt tone of the timer at the same time. In the foregoing example scenario, audio content of a plurality of applications on the electronic device is mixed together and interferes with each other, resulting in poor user experience.

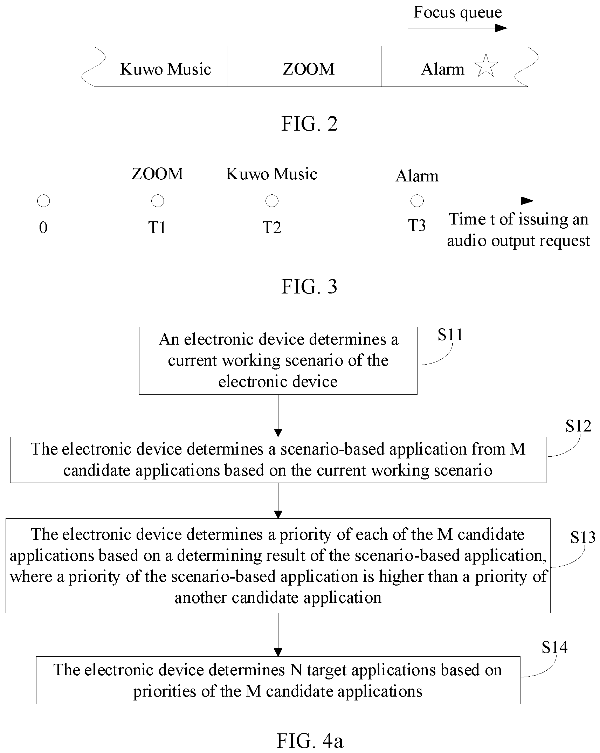

To resolve a problem of mixed playback of audio of a plurality of applications, an operating system (for example, the Android system) of some electronic device provides an audio focus mechanism. As shown in FIG. 2, in the audio focus mechanism, only one application (usually a last application that initiates a request) may output audio at one moment. Specifically, the operating system allocates a focus to the last application that initiates a request, and outputs audio of the application; and another application loses a focus and audio output of the another application is paused. After an application (which is an alarm in the figure) that currently outputs audio releases a focus, a next application (which is ZOOM in the figure) adjacent to the current application in a focus queue obtains the focus. Because the audio focus mechanism specifies that one electronic device can output audio of only one application at a same moment, the problem of mixed playback of audio of a plurality of applications can be resolved. However, in the audio focus mechanism, only the last application that sends a request can output audio, which has low flexibility of audio output. In addition, when the user needs to obtain audio content of a plurality of applications at the same time (for example, when the user wants to listen to music and a navigation voice at the same time), the audio focus mechanism cannot meet a requirement of the user.

Therefore, an implementation of this application provides an audio output method. When the electronic device 100 receives audio output requests from M audio applications, the electronic device 100 selects N target applications from the M audio applications, outputs audio corresponding to the N target applications, and stops outputting audio of an audio application other than the target applications. M is greater than N.

In other words, in this implementation of this application, a maximum quantity (the maximum quantity is referred to as a "threshold N" in this specification) of applications (referred to as "target applications" in this specification) that output audio at a same moment is limited. When the quantity M of applications (referred to as "candidate applications" in this specification) that request to output audio is greater than the threshold N, the electronic device 100 filters the candidate applications, to limit the quantity of target applications to N. By limiting the quantity of target applications, this implementation of this application can improve a case in which audio of a plurality of applications interferes with each other in a conventional technology.

In addition, in this implementation of this application, the N target applications may be selected from the M candidate applications based on any filtering condition (for example, a filtering condition specified by a user). Therefore, compared with an audio focus mechanism in the conventional technology, in this implementation of this application, a target application that outputs audio can be determined in a more flexible manner, thereby improving user experience.

In some implementations of this application, N is a positive integer greater than 2. In other words, in this implementation of this application, a plurality of target applications (provided that a quantity of target applications does not exceed N) are allowed to output audio at the same time. Therefore, a requirement of the user for listening to a plurality of pieces of audio at the same time can be met.

A type of the electronic device is not limited in this implementation of this application. The electronic device may be a mobile phone, a notebook computer, a tablet computer, a largescreen device, a wearable device (for example, a watch, smart glasses, or a helmet), a desktop computer, an augmented reality (Augmented Reality, AR)/virtual reality (Virtual Reality, VR) device, a personal digital assistant (Personal Digital Assistant, PDA), or the like.

An audio application is not limited in this implementation of this application. The audio application may be a system application such as a phone application, a timer application, a smart voice application, or a browser application (for example, safari^{™}); or may be a third-party application such as a music application (for example, Kuwo Music^{™}), a video application (for example, iQIYI^{™}), a conference application (for example, ZOOM^{™}), a game application (for example, PUBG Mobile^{™} or Battle City^{™}), a payment application (for example, Alipay^{™}), a short video application (for example, TikTok^{™}), a social application (Sina Weibo^{™}), a navigation application (for example, Baidu Maps^{™}), an e-book application (for example, Seven-Cat Novel^{™}), or a radio application (for example, Dragonfly FM^{™}), provided that audio can be output. Details are not described.

The following provides examples in which the electronic device 100 selects N target applications from M candidate applications. In the following examples, M=3, and N=2. FIG. 3 shows an example scenario in which three candidate applications on an electronic device send an audio output request to the electronic device. Refer to FIG. 3. The three candidate applications are ZOOM, Kuwo Music, and an alarm. ZOOM is the first application that sends an audio output request, and the alarm is the last application that sends an audio output request.

### (1) Example 1: The electronic device 100 selects two target applications from the three candidate applications based on a current working scenario.

Refer to FIG. 4a. This example includes the following steps:

S 11: The electronic device 100 determines a current working scenario of the electronic device 100.

In some embodiments, the electronic device 100 determines the current working scenario based on device information of an external communication device (another electronic device that establishes a communication connection to the electronic device 100). For example, when the electronic device 100 is connected to a vehicle-mounted speaker, the electronic device 100 determines that the current working scenario of the electronic device 100 is an in-vehicle scenario; or when the electronic device 100 is connected to a home gateway, the electronic device 100 determines that the current scenario of the electronic device 100 is a home scenario; and so on.

In some embodiments, the electronic device 100 determines the current working scenario based on an application running on the electronic device 100. For example, when a PPT application or a conference application (for example, ZOOM) runs on the electronic device 100, the electronic device 100 determines that the current working scenario is a conference scenario; or when a fitness application (for example, KEEP) runs on the electronic device 100, the electronic device 100 determines that the current working scenario is a motion scenario; and so on.

In some embodiments, the electronic device 100 determines the current working scenario based on measurement data of a specific sensor, where the specific sensor is configured to measure a displacement, a speed, and/or acceleration data of the electronic device 100. For example, the specific sensor is a gyro sensor, an acceleration sensor, a GPS sensor, or the like. Specifically, when measurement data of the acceleration sensor meets a data feature of the motion scenario, the electronic device 100 determines that the current working scenario is a motion scenario (for example, walking or running). When it is determined, based on measurement data of the GPS sensor, that a current moving speed of the electronic device 100 falls within a specified interval (for example, 180 km/h to 300 km/h), the electronic device 100 determines that the current scenario is a high-speed rail travel scenario.

The electronic device 100 may further determine the current working scenario based on another condition. For example, the electronic device acquires image data of a current environment through a camera, or acquires sound data of the current environment through a microphone, and determines the current working scenario by using an AI algorithm. Details are not described.

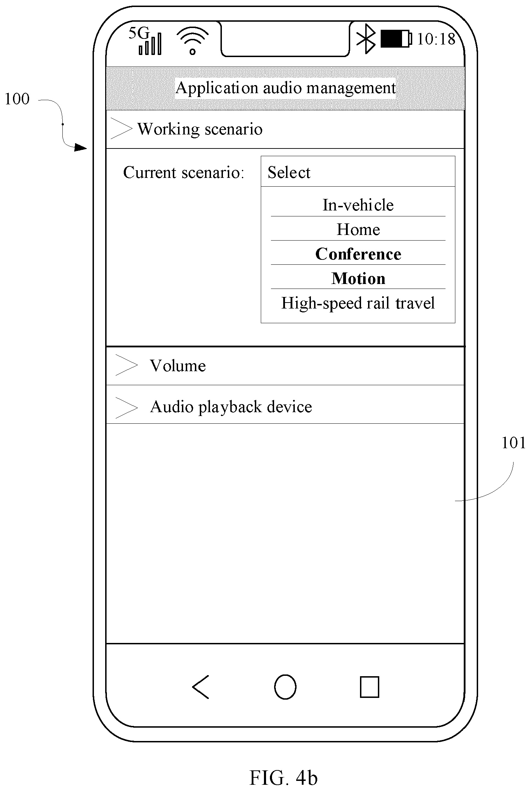

In the foregoing embodiment, the electronic device 100 automatically senses the current working scenario based on a preset condition. However, this application is not limited thereto. In another embodiment, the electronic device 100 may determine the current working scenario based on a scenario specifying operation of a user. FIG. 4b shows an example of a scenario specifying operation of a user. An interface 101 shown in FIG. 4b may be displayed when the user selects an "application audio management" option of a system settings application. The interface 101 includes a scenario selection list. When the user selects "a conference scenario" from the scenario selection list, the electronic device 100 determines that the current working scenario is a conference scenario. In this example, the scenario specifying operation is an operation performed by the user on the interface 101. However, this application is not limited thereto. In another embodiment, the scenario specifying operation may be another operation of the user, for example, sending a voice instruction to the electronic device 100.

S12: The electronic device 100 determines a scenario-based application from the three candidate applications based on the current working scenario, where the scenario-based application is an application required in the current working scenario.

In an example, the electronic device 100 stores a table of "scenario-application" relationships. Table 1 shows an example of the table of "scenario-application" relationships. The "scenario" column lists working scenarios, and the "application" column lists applications (that is, scenario-based applications) required by various working scenarios. After determining the current working scenario, the electronic device 100 may determine a scenario-based application by querying the table of "scenario-application" relationships. For example, after determining that the current working scenario is the high-speed rail travel scenario, the electronic device 100 determines the "alarm" application as the scenario-based application.

**Table 1 Table of "scenarios-application" relationships**

| Scenario | Scenario-based application |
|---|---|
| In-vehicle scenario | Baidu Maps; Dragonfly FM; and Kuwo Music |
| Home scenario | AI life; and Midea Meiju |
| Conference scenario | ZOOM; and Tencent Meeting |
| Motion scenario | KEEP; |
| High-speed rail travel scenario | Alarm; and Seven-Cat Novel |

Table 1 may be generated by the electronic device based on application labels of various audio applications. The application label may be defined in an attribute file (for example, an "AndroidManifest.xml" file of an android application) of the application. The application label is used to indicate a purpose of an application. For example, a label of Baidu Maps is "navigation", and labels of Dragonfly FM and Kuwo Music are "entertainment". When determining Table 1, the electronic device determines, based on the application labels, scenario-based applications corresponding to the scenarios. For example, the electronic device determines all applications whose application labels are "navigation" and "entertainment" as scenario-based applications for the in-vehicle scenario. In addition, a correspondence between a scenario and an application label may be preset at delivery of the electronic device, or may be specified by the user by using the system settings application.

Table 1 may alternatively be determined by using the AI algorithm. In a use process of the electronic device, statistics on audio applications running on the electronic device in each scenario are collected, and an AI model is trained by using a statistical result. Then, the electronic device may calculate a use probability of each application in a preset scenario based on the AI model, and determine an application whose use probability exceeds a specified threshold (for example, 70%) as a scenario-based application for the preset scenario.

S13: The electronic device 100 determines a priority of each of the M candidate applications based on a determining result of the scenario-based application, where a priority of the scenario-based application is higher than a priority of another candidate application.

Refer to the scenario shown in FIG. 3. When the electronic device 100 works in a conference scenario, the electronic device determines, according to Table 1, that the scenario-based application is the ZOOM application. Therefore, the electronic device 100 determines the ZOOM application as an application with a highest priority in the three candidate applications. Then, the electronic device 100 determines priorities of remaining applications based on an order of moments at which audio output requests are sent. Specifically, an application that sends a request latter has a higher priority. Therefore, a priority of the alarm is higher than a priority of Kuwo Music. Finally, priorities of the three candidate applications are sorted in descending order as follows: ZOOM, the alarm, and Kuwo Music.

When the electronic device 100 works in the high-speed rail travel scenario, the electronic device determines, according to Table 1, that the scenario-based application is the alarm application. Therefore, the electronic device 100 determines the alarm application as an application with a highest priority in the three candidate applications. Then, the electronic device 100 determines priorities of remaining applications based on an order of moments at which audio output requests are sent. Specifically, an application that sends a request later has a higher priority. Therefore, a priority of the Kuwo Music is higher than a priority of ZOOM. Finally, priorities of the three candidate applications are sorted in descending order as follows: the alarm, Kuwo Music, and ZOOM.

It should be noted that when there are a plurality of scenario-based applications, the electronic device 100 may determine priorities of the scenario-based applications based on an order of moments at which audio output requests are sent. Specifically, an application that sends an audio output request later has a higher priority. For example, in an example, the current working scenario of the electronic device is the high-speed rail travel scenario, and scenario-based applications determined by the electronic device include the alarm application (used for reminding time) and the Seven-Cat Novel (used for relaxation during a travel). An application that sends an audio output request later in the two applications is the alarm application. Therefore, the electronic device determines that a priority of the alarm is higher than a priority of Seven-Cat Novel.

S14: The electronic device 100 determines two target applications based on the priorities of the three candidate applications.

Specifically, the electronic device 100 determines two applications with highest priorities as the two target applications based on an order of priorities of the three candidate applications. Because the priority of the scenario-based application is higher than the priority of another candidate application, the two target applications may include at least the scenario-based application determined in step S12. Specifically, for the conference scenario described in step S13, the electronic device 100 determines ZOOM and the alarm as the two target applications; and for the high-speed rail travel scenario described in step S13, the electronic device 100 determines the alarm and Kuwo music as the two target applications.

In this example, the electronic device 100 selects the N target applications from the M candidate applications based on the current working scenario, and the N target applications include at least the scenario-based application required in the current working scenario, so that audio output by the electronic device 100 better matches the current working scenario. This helps improve user experience.

### (2) Example 2: The electronic device 100 selects two target applications from the three candidate applications based on preset application priority information.

Some key applications are important to the user, and may need to have a high priority, so that the user can listen to, in a timely manner, audio content output by these applications. Generally, such applications are a call application (for example, a system phone application), a notification application (for example, a timer application or a calendar reminder application), a payment application (for example, Alipay), a human-computer interaction application (for example, AI voice), and the like. Priority information corresponding to such applications is preset in the electronic device 100. The electronic device 100 may determine, by using the preset priority information, such applications as applications having high priorities.

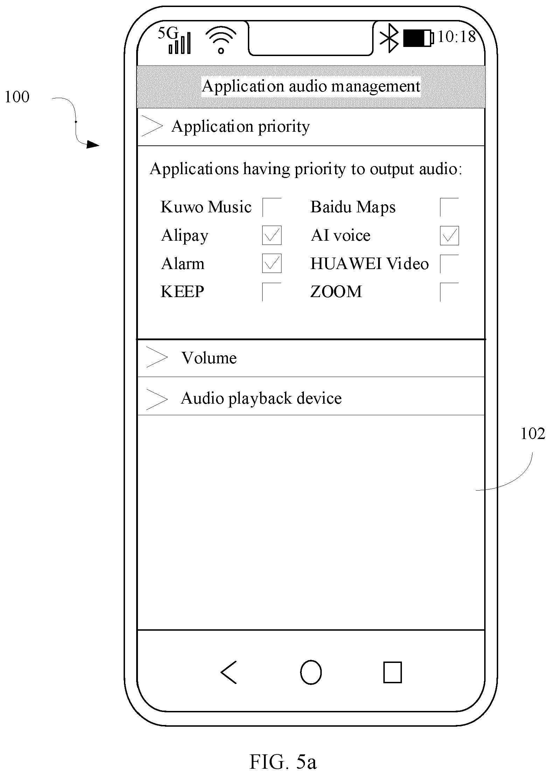

In this embodiment, the application priority information is attribute information added to an application. For example, when the attribute information of an application is Priority, it indicates that the application is an application with a high priority; or when the attribute information of an application is another value or is empty, it indicates that the application is an application with a low priority. For example, the user may set the attribute information of an application through an interface 102 shown in FIG. 5a. For example, after ticking a check box on the right of Alipay, the user may set attribute information of Alipay to Priority. In addition, the electronic device 100 may alternatively set attribute information of a specific application (for example, the system phone application) to Priority in factory settings of the electronic device 100.

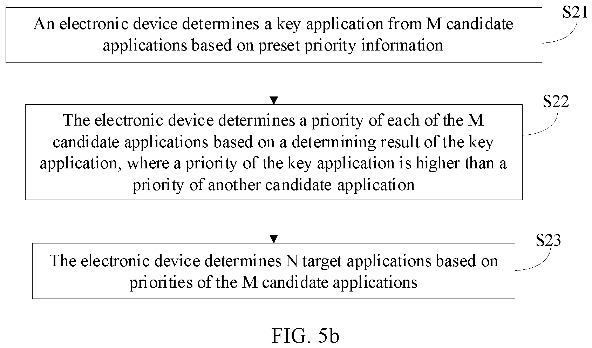

Refer to FIG. 5b. In this example, a method for selecting two target applications from the three candidate applications by the electronic device 100 includes the following steps:

S21: The electronic device 100 determines a key application from the three candidate applications based on the preset application priority information.

Specifically, the electronic device 100 determines the key application based on attribute information of each candidate application. When attribute information of an application is Priority, the electronic device 100 determines the application as the key application. With reference to FIG. 3 and FIG. 5a, in this example, the electronic device 100 determines the alarm as the key application.

S22: The electronic device 100 determines a priority of each of the three candidate applications based on a determining result of the key application, where a priority of the key application is higher than a priority of another candidate application.

Because the alarm is the key application, the electronic device 100 determines the alarm as an application with a highest priority in the three candidate applications. Then, the electronic device 100 determines priorities of remaining applications based on an order of moments at which audio output requests are sent. Specifically, an application that sends a request later has a higher priority. Therefore, a priority of the Kuwo Music is higher than a priority of ZOOM. Finally, priorities of the three candidate applications are sorted in descending order as follows: the alarm, Kuwo Music, and ZOOM.

It should be noted that, the electronic device 100 may determine priorities of various key applications based on an order of moments at which audio output requests are sent. Specifically, an application that sends an audio output request later has a higher priority. For example, in a scenario, an application 1, an application 2, and an application 3 sequentially send an audio output request, and the three applications are all key applications. The electronic device 100 determines that the three applications are sorted in descending order of priorities as follows: the application 3, the application 2, and the application 1.

S23: The electronic device 100 determines three target applications based on the priorities of the three candidate applications.

Same as step S13, the electronic device 100 determines two applications with highest priorities as the N target applications. Therefore, in this example, the electronic device 100 determines the alarm and Kuwo Music as two target applications.

In this example, the electronic device 100 selects the two target applications from the three candidate applications based on the preset priority information. Therefore, audio of the key applications may be first output, which helps improve user experience.

### (3) Example 3: The electronic device 100 selects two target applications from the three candidate applications based on a selection operation performed by the user on the three candidate applications.

In this example, the selection operation performed by the user on the three candidate applications is a selection operation performed by the user on an application selection interface of the electronic device 100. When a quantity of candidate applications exceeds the threshold N, the electronic device 100 displays the application selection interface, so that the user may select, through the application selection interface, an application (namely, the target application) that is expected to output audio.

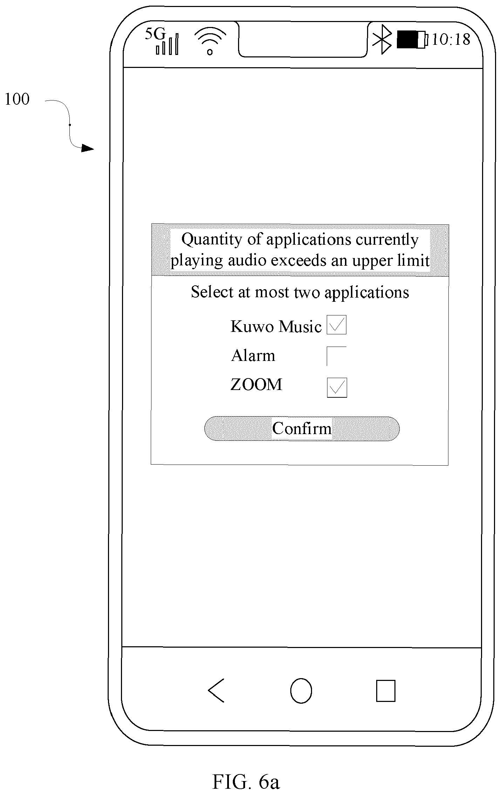

FIG. 6a shows an example of an application selection interface. The user may select, by ticking a check box corresponding to a candidate application, an application that is expected to output audio. For example, in FIG. 6a, the user ticks check boxes corresponding to ZOOM and Kuwo Music. Therefore, the electronic device 100 determines ZOOM and Kuwo Music as two target applications based on selection of the user.

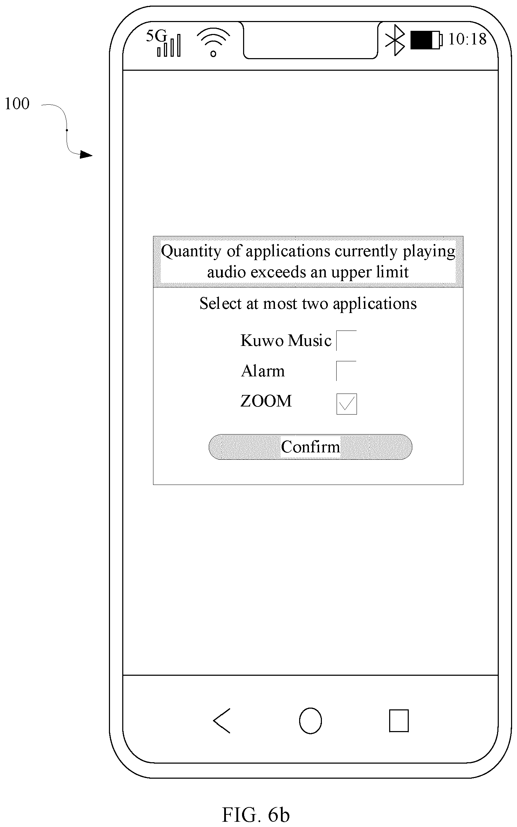

In another case, a quantity of applications ticked by the user is less than the threshold N. In this case, the electronic device 100 selects, from remaining applications, a last application that requests to output audio, and the selected application, together with the applications ticked by the user, forms the N target applications. Specifically, as shown in FIG. 6b, when the user ticks only the ZOOM application, the electronic device 100 selects, from the Kuwo Music application and the alarm application, a last application (specifically, the alarm application) that requests to output audio, and uses the ZOOM application and the alarm application as the two target applications.

In this example, the selection operation of the user is an operation performed by the user on the application selection interface. However, this application is not limited thereto. In another embodiment, the selection operation of the user may be another operation of the user, for example, sending a voice instruction to the electronic device.

The foregoing Example 1 to Example 3 are examples for description of the implementations of this application. A person skilled in the art may make other variations. For example, the threshold N may be another value greater than 2 (for example, 3 or 6), and M may be another value greater than N (for example, 5 or 8).

The foregoing describes the method for selecting the N target applications from the M candidate applications by the electronic device 100. The following describes a specific process of the audio output method provided in embodiments of this application.

In embodiments of this application, an audio output process is controlled with an idea of an audio focus mechanism. In a conventional technology, an existing electronic device allows only one application to obtain a focus at a same moment (that is, there is one focus). Different from the conventional technology, in this embodiment, a maximum of N applications are allowed to obtain a focus at a same moment (that is, there may be a maximum of N focuses).

Specifically, after candidate applications send audio output requests to an operating system, the operating system determines whether a quantity M of candidate applications that currently send the requests exceeds a threshold N. If the quantity does not exceed the threshold N, the operating system allocates focuses to all applications in the M candidate applications, to output audio of the M candidate applications. If the quantity M exceeds the threshold N, the operating system selects N target applications from the M candidate applications, and allocates focuses to the N target applications, to output audio of the N target applications.

In an implementation of this application, the electronic device may play (as "output") audio of the target application through an audio playback apparatus (for example, a microphone) of the electronic device, or may play audio of the target application through another audio playback device (for example, a Bluetooth speaker) that is communicatively connected to the electronic device.

In addition, in this implementation of this application, the electronic device may set the threshold N based on a requirement. For example, when the electronic device 100 is not connected to another audio playback device, the electronic device 100 sets N to a small value (for example, N=2); or when the electronic device 100 is connected to another audio playback device, the electronic device 100 sets N to a large value. For example, when there are four other audio playback devices connected to the electronic device 100, the electronic device 100 sets N to 6. In another example, the electronic device 100 may alternatively determine the threshold N based on a user input.

The following describes specific embodiments of this application.

### Embodiment 1

The following still describes the audio output method provided in this embodiment with reference to the scenario shown in FIG. 3. Refer to FIG. 3. ZOOM, Kuwo Music, and an alarm application on the electronic device 100 respectively send an audio output request to an operating system at a moment T 1, a moment T2, and a moment T3. In addition, in this embodiment, N=2. In another embodiment, N may be another integer, for example, 1, 4, or 7.

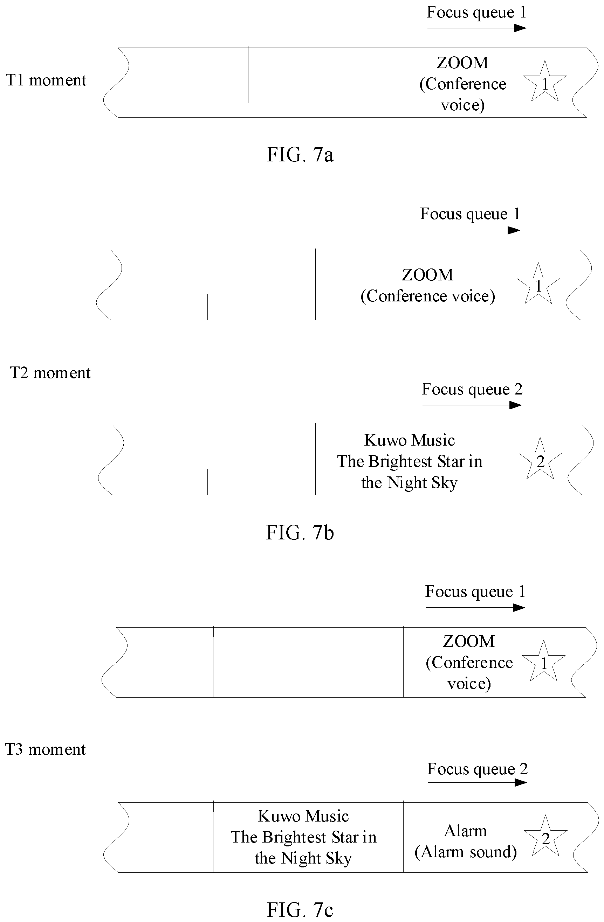

For ease of understanding, focus queues (namely, audio output queues) at different moments in this embodiment are first provided. At the moment T1, refer to FIG. 7a. After ZOOM sends the audio output request to the operating system, the operating system determines that a quantity M of candidate applications that currently send a request is 1, which does not exceed the threshold N (N=2). Therefore, the operating system allocates a first focus to ZOOM, and outputs audio of ZOOM through a focus queue 1.

At the moment T2, as shown in FIG. 7b, after Kuwo Music sends the audio output request to the operating system, the operating system determines that the quantity M of candidate applications that currently send a request is 2, which does not exceed the threshold N (N=2). Therefore, the operating system allocates a second focus to Kuwo Music, and outputs audio of Kuwo Music through a focus queue 2.

At the moment T3, after the alarm sends the audio output request to the operating system, the operating system determines that the quantity M of candidate applications that currently send a request is 3, which exceeds the threshold N (N=2). Therefore, the operating system readjusts the focus queue to output audio of the two target applications. In this embodiment, an audio output queue at the moment T3 is shown in FIG. 7c. The electronic device 100 outputs audio of ZOOM and audio of the alarm.

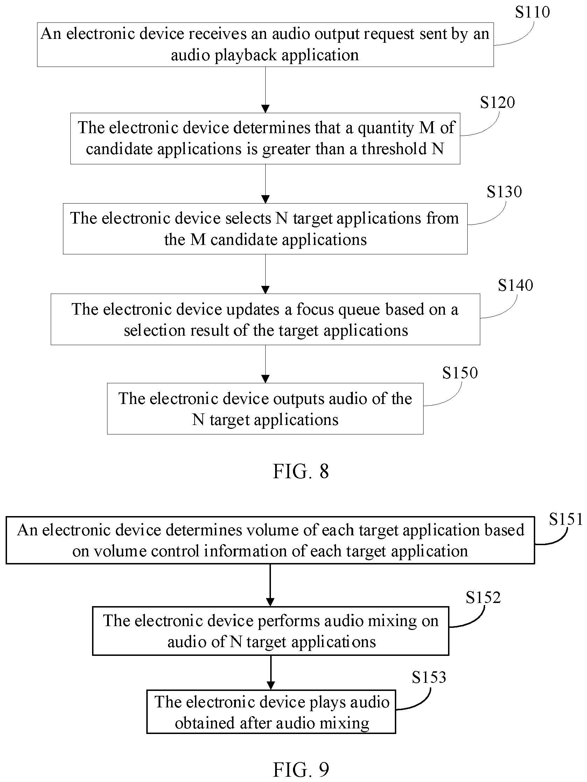

The following describes specific steps of the audio output method provided in this embodiment with reference to FIG. 8. To highlight a difference between this embodiment and a conventional technology, the following steps are described with reference to an audio output process after the moment T3.

S110: The electronic device 100 receives an audio output request sent by an audio application.

In this embodiment, the alarm is used as an example of the audio application. After a specified time of the alarm expires, an audio output request is sent to the operating system. For example, the alarm application sends the audio output request to the operating system by invoking an audio player (for example, MediaPlayer or AudioTrack in an Android system) provided by the system. After the audio application sends the audio output request to the operating system, the electronic device 100 receives the audio output request.

The audio output request sent by the audio application may include an application identifier (for example, an application name) of the application, file information (for example, a name of an audio file, an address of the audio file, and a compression format of the audio file) of the audio file that is requested to be output, and the like.

In this embodiment, the alarm application is used as an example of the audio application, but this application is not limited thereto. In another embodiment, the audio application may be another application, for example, TikTok or a browser. In addition, a trigger condition for each audio application to send an audio output request to the operating system may be determined based on a function of the audio application. For example, for a short video application such as TikTok, after a user opens a video playback interface, the application sends an audio output request to the operating system; for a music playback application such as Kuwo Music, after the user taps a "play" button, the application sends an audio output request to the operating system; for a notification application such as a calendar reminder, when a specified condition is met (for example, a specified time expires, or a specified event occurs), the application sends an audio output request to the operating system; or for an online audio playback application (for example, a browser), after audio data is buffered, the application sends an audio output request to the operating system. For an application that is not described above, refer to examples in the conventional technology. Details are not described.

S120: The electronic device 100 determines that the quantity M of candidate applications is greater than the threshold N.

The operating system stores a list of candidate applications. When receiving a new request, the operating system determines whether the request is from a new application (that is, an application that is not included on the application list). If the request is from a new application, the operating system adds 1 to the current quantity M, and adds an application identifier of the new application to the application list. If the request is not from a new application, the operating system maintains the current quantity M and the application list unchanged.

In this embodiment, before the moment T3, the application list includes Kuwo Music and ZOOM, and the quantity M of candidate applications is 2. When receiving the audio output request from the alarm application at the moment T3, the operating system determines, based on the application list, that the alarm application is a new application, and therefore updates the quantity M of applications to 3, and adds an application identifier (for example, an application name) of the alarm application to the application list.

After updating the quantity M (M=3) of applications, the operating system compares the quantity M of applications with the threshold N (N=2), to determine that the quantity M of candidate applications that currently send the request is greater than the threshold N.

In addition, in an audio output process, when the operating system determines that audio output of a candidate application ends, the operating system subtracts 1 from the quantity M of applications, and deletes an application identifier of the candidate application from the application list. For a method for determining, by the operating system, that audio output of the candidate application ends, refer to the conventional technology. This embodiment merely provides an example for description. For example, when the operating system receives an audio output end instruction (for example, the application sends the audio output end instruction to the operating system by invoking a MediaPlayer.stop() method provided by the Android system) sent by the candidate application, the operating system determines that the application ends audio output; or when the operating system reads an end mark of an audio file of the candidate application, the operating system determines that the application ends audio output.

S130: The electronic device 100 selects N target applications from the M candidate applications.

For a method for selecting the N target applications from the M candidate applications by the operating system, refer to the descriptions in Example 1 (for example, steps S11 to S14), Example 2 (for example, steps S21 to S23), and Example 3. Details are not described again.

In this embodiment, a target application determined in a conference scenario in step S14 is used as an example for description. In other words, in this embodiment, target applications are ZOOM and the alarm.

S140: The electronic device 100 updates the focus queue based on a selection result of the target applications.

As described in step S130, refer to FIG. 7c. After determining ZOOM and the alarm as the target applications, the electronic device 100 keeps allocating the first focus to ZOOM, and allocates the second focus to the alarm (the second focus is allocated to Kuwo Music before the moment T3). In addition, the operating system arranges Kuwo Music after the alarm in the focus queue 2.

S150: The electronic device 100 outputs audio of the N target applications. Refer to FIG. 9. A process of outputting audio by the electronic device 100 specifically includes the following steps:

S151: The electronic device 100 determines volume of each target application based on volume control information of each target application.

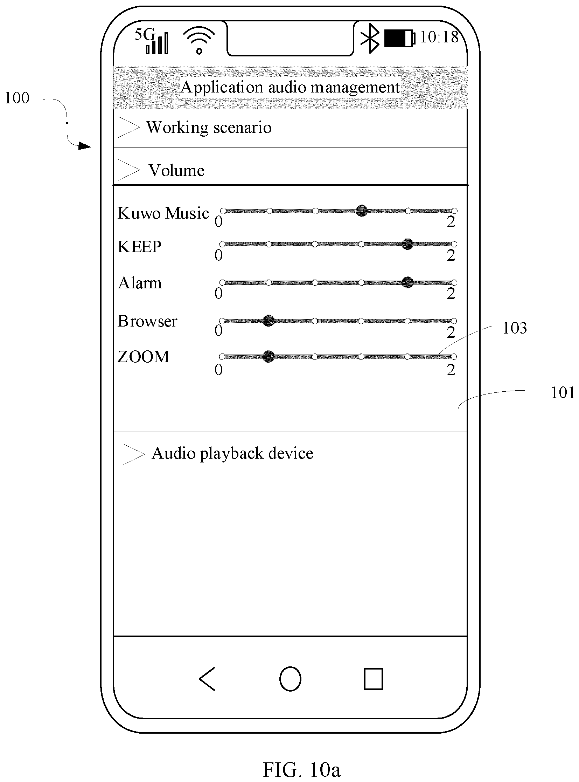

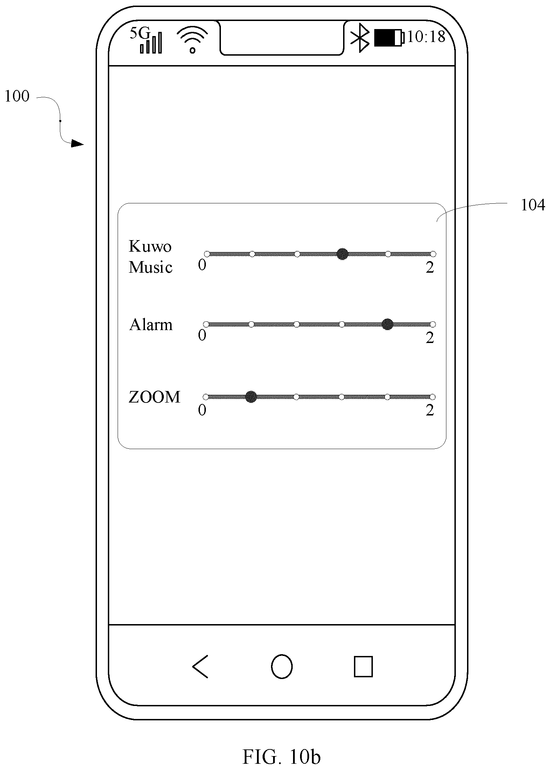

In this embodiment, the electronic device 100 includes a plurality of pieces of volume control information, and the audio applications correspond to different volume control information. For example, the user may set the volume control information of the audio applications by using methods shown in FIG. 10a and FIG. 10b. In other words, in this embodiment, the volume control information of each audio application may be determined based on a user input.

FIG. 10a shows a manner in which the user sets volume control information. After the user selects the "application audio management" option of a system settings application, an interface 101 shown in FIG. 10a is displayed. The interface 101 includes volume control bars corresponding to all audio applications, and each position of the volume control bar may be mapped to a volume adjustment coefficient (used as the volume control information). The volume control bar further includes a volume control ball. The user may set volume corresponding to the audio application by dragging the volume control ball. Using ZOOM as an example, ZOOM corresponds to a volume control bar 103. When the user drags a volume control ball on the volume control bar 103 to a position shown in FIG. 10a, the user may set a volume adjustment coefficient of ZOOM to 0.4.

FIG. 10b shows another manner in which the user sets volume control information. In the manner shown in FIG. 10b, the user may adjust volume of the target application more quickly. Specifically, when the user operates the electronic device 100 in a predetermined manner, the electronic device 100 displays an interface 104 shown in the figure. The predetermined manner may be understood as a shortcut of invoking the interface 104. The predetermined manner is, for example, pressing a predetermined button (for example, a volume button), swiping a screen by using a predetermined gesture (for example, a four-finger swiping gesture), and shaking the electronic device 100 in a predetermined direction (a direction perpendicular to a plane on which the electronic device 100 is located). This is not limited in this application.

The interface 104 includes volume control bars corresponding to the target applications. The user may adjust the volume of each target application in real time by dragging a volume control ball on the volume control bar. In this way, when the electronic device 100 outputs audio of the target applications, the user may quickly adjust volumes of the target applications in the manner shown in FIG. 10b.

When the electronic device 100 outputs audio of each target application, the operating system determines volume of the target application based on the volume control information of each target application, and outputs the audio of the target application at the volume. ZOOM shown in FIG. 10a is still used as an example. In this specification, audio data (for example, decoded PCM audio data) that ZOOM requests to output is denoted as Data_1. When a volume control ball of ZOOM is dragged to the position shown in FIG. 10a, the operating system uses 0.4×Data_1 as output audio of ZOOM.

In this embodiment, each audio application corresponds to one piece of independent volume control information. In this way, the volume of each audio application can be independently controlled. However, this application is not limited thereto. In another embodiment, a plurality of audio applications may share a same piece of audio control information. For example, the electronic device 100 classifies audio applications into a plurality of application groups based on application labels of the applications (for example, Dragonfly FM and Seven-Cat Novel are classified into an entertainment application group based on an "entertainment" label), and each application group corresponds to one volume control bar. In this way, the user may adjust volumes of all applications in the application group by operating one volume control bar.

S152: The electronic device 100 performs audio mixing on audio of the N target applications. Specifically, the operating system overlays output audio data of the N target applications, to generate audio data Data_Final finally output by the electronic device 100.

Refer to FIG. 10a. Audio data of ZOOM is Data_1, and a volume adjustment coefficient is 0.4; and audio data of the alarm is Data_2, and a volume adjustment coefficient is 1.6. In this case, after the audio mixing operation, the electronic device 100 finally outputs audio data Data_Final=0.4×Data_1+1.6×Data_1.

S 153 : Electronically play audio obtained after audio mixing. Specifically, the operating system sends the audio data Data_Final to an audio output apparatus (for example, a speaker) of the electronic device 100, to play audio of the two target applications through the audio output apparatus.

In conclusion, when the quantity M of candidate applications exceeds the threshold N, a quantity of applications (namely, target applications) that output audio may be limited to N in this embodiment. By limiting the quantity of target applications, this embodiment can be used to improve a case in which audio of a plurality of applications interferes with each other in the conventional technology. In addition, in this embodiment, a plurality of applications are allowed to output audio at the same time (that is, N≥2), so that a requirement of the user for listening to audio of the plurality of applications at the same time can be met.

In addition, in this embodiment, the volume control information of each application may be independently set. In this way, the user can adjust the volume of each application as needed, so that user experience is improved. For example, when the user does not want to hear a voice in ZOOM, and it is inappropriate to exit the ZOOM application, the user may increase volume of Kuwo Music, and decrease volume of ZOOM. In this way, a sound of Kuwo Music can cover a sound of ZOOM to meet a requirement of the user.

This embodiment is an example description of the technical solutions of this application, and a person skilled in the art may make other variations. For example, in another embodiment, the electronic device 100 sets a system phone application as a special example of an audio application, and does not include the system phone application in candidate applications (that is, the candidate applications include only an application other than the system phone application). In this embodiment, the system phone application is not limited by the threshold N, and the electronic device 100 may output audio of the system phone application and audio of the N target applications at the same time. In other words, when the user answers a call through the system phone application, the electronic device 100 may output audio of (N+1) applications.

### Embodiment 2

In this embodiment, step S150 in Embodiment 1 is improved. In step S150 in Embodiment 1, audio of N target applications is played through a same audio playback device (namely, the electronic device 100). In this embodiment, audio of the N target applications is played through different audio playback devices.

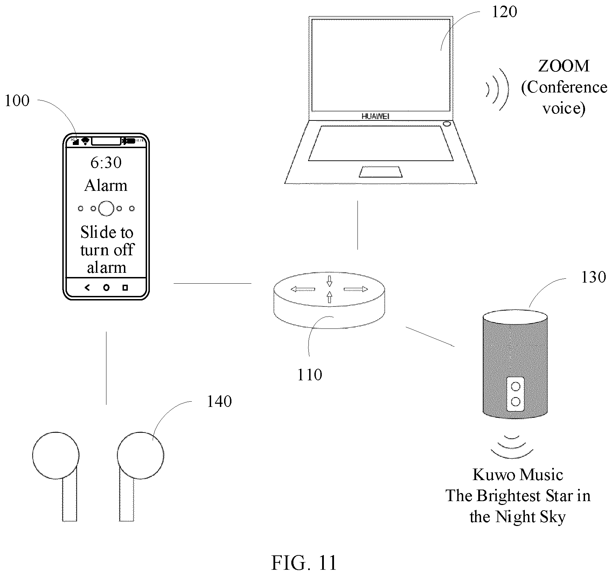

FIG. 11 shows an example application scenario of this embodiment. In FIG. 11, an electronic device 100 (specifically, a mobile phone) is communicatively connected to a notebook computer 120 (a device name "Laptop") and a speaker 130 (a device name "AI speaker") through a gateway 110, and is communicatively connected to a Bluetooth headset 140 (a device name "FreeBuds") through Bluetooth.

The scenario shown in FIG. 3 is still used for description. Different from Embodiment 1, in this embodiment, N=3. Three target applications that are outputting audio on the electronic device 100 are ZOOM, Kuwo Music, and an alarm. Audio of Kuwo Music is played through the speaker 130, audio of ZOOM is played through the notebook computer 120, and audio of the alarm is played through the electronic device 100.

In the scenario shown in FIG. 11, the electronic device 100 (specifically, a mobile phone), the notebook computer 120, the speaker 130, and the Bluetooth headset 140 are used as examples of the audio playback device. However, this application is not limited thereto. In another embodiment, the audio playback device may be a large screen, a tablet, a vehicle-mounted speaker, a smartwatch, or another device, provided that the audio playback device can play audio. In addition, the electronic device 100 may communicate with the another audio playback device in a communication mode of Wi-Fi, Bluetooth, wired communication, or the like.

In this embodiment, the electronic device 100 includes a device information list. The device information list is used to record device information of an audio playback device (referred to as a "standby device" in this specification) other than the electronic device 100. The standby device is, for example, an audio playback device that has established a communication connection to the electronic device 100. For example, when the electronic device 100 establishes a communication connection to an audio playback device for the first time, the electronic device 100 adds device information of the audio playback device to the device information list. The device information of the standby device may include a device name, a device type, a device number (allocated by the electronic device 100), and the like.

The device information list further includes status information of each standby device. For example, when a communication status between a standby device and the electronic device 100 changes from a disconnected state to a connected state, the electronic device 100 updates "status information" of the device to "connectable"; and when a communication status between a standby device and the electronic device 100 changes from a connected state to a disconnected state, the electronic device 100 updates "status information" of the device to "unconnectable". It may be understood that when status information of a device is "connectable", it indicates that the device is an available device, and the electronic device 100 may play audio of the target application through the device.

Table 2 shows a device information list corresponding to the scenario shown in FIG. 11.

**Table 2 Device information list**

| Number | Device name | Device type | Status information |
|---|---|---|---|
| 001 | FreeBuds | Bluetooth headset | Connectable |
| 002 | AI speaker | Speaker | Connectable |
| 003 | Car speaker | Vehicle-mounted speaker | Unconnectable |
| 004 | TV | Large screen | Unconnectable |
| 005 | Laptop | Notebook computer | Connectable |
| 006 | Watch | Smartwatch | Unconnectable |

Table 2 may be understood as a data preparation process of this embodiment. The following describes, with reference to the scenario shown in FIG. 11, a process of outputting audio by the electronic device 100 in this embodiment.

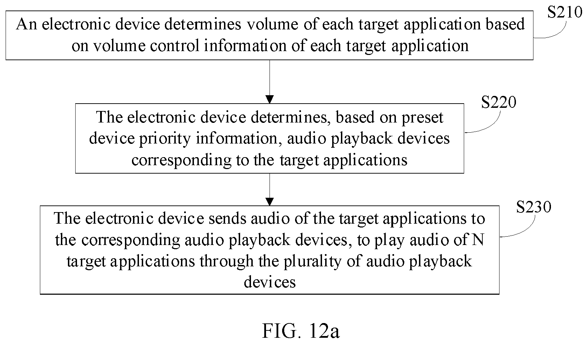

Refer to FIG. 12a. In this embodiment, a process in which the electronic device 100 outputs audio of three target applications includes the following steps:

S210: The electronic device 100 determines volume of each target application based on volume control information of each target application.

This step is substantially the same as step S151 in Embodiment 1. Therefore, refer to the descriptions in step S151 in Embodiment 1. Details are not described again.

S220: The electronic device 100 determines audio playback devices (namely, devices for playing audio of the target applications) corresponding to the target applications. The following provides several specific examples.

Example 1: The electronic device 100 determines, based on preset device priority information, an audio playback device corresponding to the target application.

For example, the device priority information in the electronic device 100 is a table of "application-device" relationships stored in the electronic device 100. Table 3 shows an example of the table of "application-device" relationships. According to Table 3, the electronic device 100 may determine a preferred playback device (namely, the audio playback device corresponding to the target application) of each target application. Specifically, an audio playback device that is listed in a same row as an audio application is a preferred playback device of the audio application. For example, "AI speaker" is a preferred playback device of Kuwo Music.

**Table 3 Table of "application-device" relationships**

| Audio application | Preferred playback device |
|---|---|
| Alarm | This device |
| Kuwo Music | AI speaker |
| Baidu Maps | Car speaker |
| Browser | TV |
| ZOOM | Laptop |
| Audio application | Preferred playback device |
| KEEP | Watch |

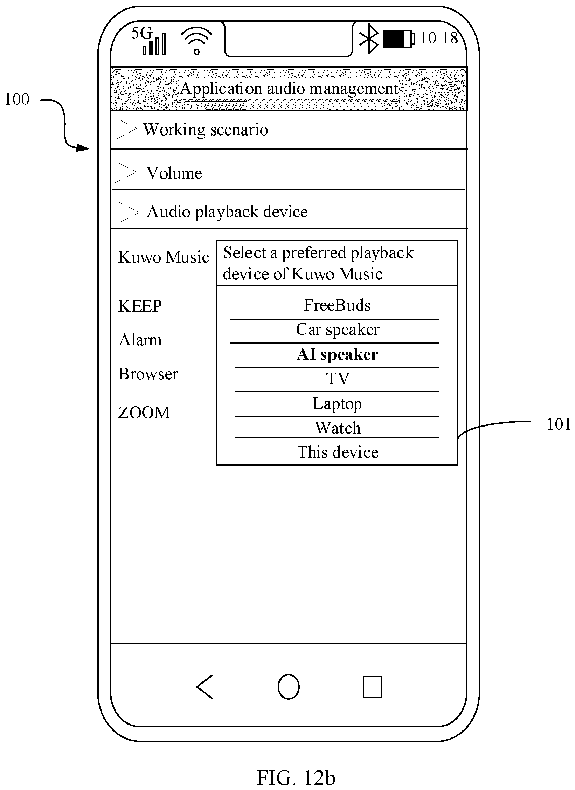

FIG. 12b shows an example method for setting device priority information. Refer to FIG. 12b. An application audio management interface 101 of the electronic device 100 includes several audio applications, and a drop-down list box is set on the right of each audio application. The drop-down list box lists names of standby devices (for example, the standby devices in Table 2). A user may set device priority information by selecting a device in the drop-down list box.

Using Kuwo Music as an example, the user sets, through the interface shown in FIG. 12b, "AI speaker (that is, the speaker 130)" as a preferred playback device of Kuwo Music. In this way, when the electronic device 100 outputs audio of Kuwo Music, if the speaker 130 is in a connectable state, the electronic device 100 determines the speaker 130 as an audio playback device corresponding to the target application, and plays the audio of Kuwo Music through the speaker 130; or if the speaker 130 is in an unconnectable state, the electronic device 100 plays the audio of Kuwo Music through an audio playback apparatus (for example, a speaker) of the electronic device 100.

In some other implementations, each audio application corresponds to a plurality of preferred playback devices. For example, the Kuwo Music application corresponds to two preferred playback devices: a first preferred playback device (for example, the speaker 130) and a second preferred playback device (for example, the smartwatch). When the electronic device 100 outputs audio of the Kuwo Music application, if the first preferred playback device is connectable, the audio of Kuwo Music is played through the first preferred playback device; if the first preferred playback device is unconnectable, the audio of Kuwo Music is played through the second preferred playback device; or if both the first preferred playback device and the second preferred playback device are unconnectable, the audio of the Kuwo Music application is played through the electronic device 100.

Example 2: The electronic device 100 determines, based on a quantity of times a target application is played on each of audio playback devices, an audio playback device corresponding to the target application.

The electronic device 100 stores quantities of times the target application is played on each of the audio playback devices. Still using Kuwo music as an example, according to a record stored in the electronic device 100, Kuwo music is played on "Watch" 30 times, played on "AI speaker (that is, the speaker 130)" 24 times, and played on "FreeBuds" 10 times, and there is no record of playing Kuwo Music on another device.

When the electronic device 100 outputs audio of Kuwo Music, an operating system selects, from currently connectable devices according to Table 2, a device that plays Kuwo Music a largest quantity of times as an audio playback device corresponding to Kuwo Music. In this embodiment, a device that is in the currently connectable devices and that plays Kuwo Music a largest quantity of times is the speaker 130. Therefore, the electronic device 100 plays the audio of Kuwo Music through the speaker 130.

Because a user usually selects a favorite device to play audio, a quantity of times the target application is played on the audio playback device may reflect a user preference. In this example, an audio playback device corresponding to a target application is determined based on a quantity of times the target application is played on each of the audio playback devices. Therefore, the user preference can be more satisfied, and user experience can be improved.

Example 3: The electronic device 100 determines, based on a real-time input of a user, an audio playback device corresponding to a target application.

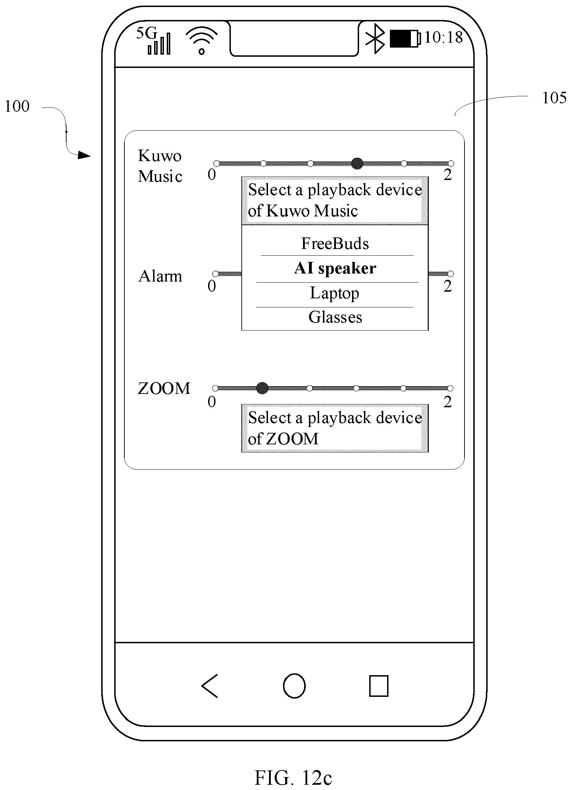

FIG. 12c shows a manner in which the user specifies an audio playback device in real time. An interface 105 shown in FIG. 12c is a further improvement of the interface 104 shown in FIG. 10b. Specifically, a device selection option is added to FIG. 12c based on FIG. 10b. In other words, in addition to a volume control bar corresponding to the target application, FIG. 12c further includes an audio playback device selection list corresponding to the target application. The device selection list includes currently connectable audio playback devices, for example, connectable devices determined according to Table 2. The device selection list may further include a device newly discovered by the electronic device 100, for example, device "Glasses" in FIG. 12c. This helps the user select a proper audio playback device in a new environment. The user may select an audio playback device of the target application through the operation interface 105. For example, after the user taps "AI speaker", the electronic device 100 determines "AI speaker" as an audio playback device of Kuwo Music.

In addition, the user may invoke the interface shown in FIG. 12c with a shortcut that is the same as that in FIG. 10b, for example, pressing a volume button or tapping a screen by using a specific gesture. In other words, this example can provide a shortcut for the user to select an audio output device.

S230: The electronic device 100 sends audio of the target applications to the corresponding audio playback devices, to play audio of the three target applications through the plurality of audio playback devices.

Refer to FIG. 11. In this embodiment, the electronic device 100 determines, according to the example in step S230, the speaker 130 as the audio playback device of Kuwo Music, the notebook computer 120 as an audio playback device of ZOOM, and the electronic device 100 as an audio playback device of an alarm.

In this way, the electronic device 100 sends the audio of Kuwo Music to the speaker 130, to play the audio of Kuwo Music through the speaker 130; sends audio of ZOOM to the notebook computer 120, to play voice of ZOOM through the notebook computer 120; and sends the audio of the alarm to a speaker of the electronic device 100, to play an alarm sound through the speaker.

In this embodiment, audio of the target applications is output through different audio playback devices, so that not only mutual interference between audio of different applications can be further avoided, but also audio of the target applications can be played through a device expected by the user, thereby improving user experience.

It should be noted that this embodiment is an example of description of the technical solutions of this application, and a person skilled in the art may make other variations.

For example, in this embodiment, the audio playback devices include the electronic device 100. However, this application is not limited thereto. In another embodiment, the audio playback devices may not include the electronic device 100, but include only a plurality of external devices (the external devices are audio playback devices other than the electronic device 100).

For another example, in this embodiment, audio of the three target applications is respectively played through three audio playback devices, and each audio playback device plays audio of one target application. However, this application is not limited thereto. In another scenario, each audio playback device may play audio of a plurality of (for example, two or three) target applications. For example, in an in-vehicle scenario, the vehicle-mounted speaker can play audio of Baidu Maps, audio of Dragonfly FM, and audio of phone at the same time. When the external device plays audio of a plurality of applications, the electronic device 100 may complete audio mixing, in the electronic device 100, for the plurality of applications, and send audio obtained after audio mixing to the external device. Alternatively, audio of applications may be independently sent to the external device, and the external device completes audio mixing of the plurality of applications.

### Embodiment 3

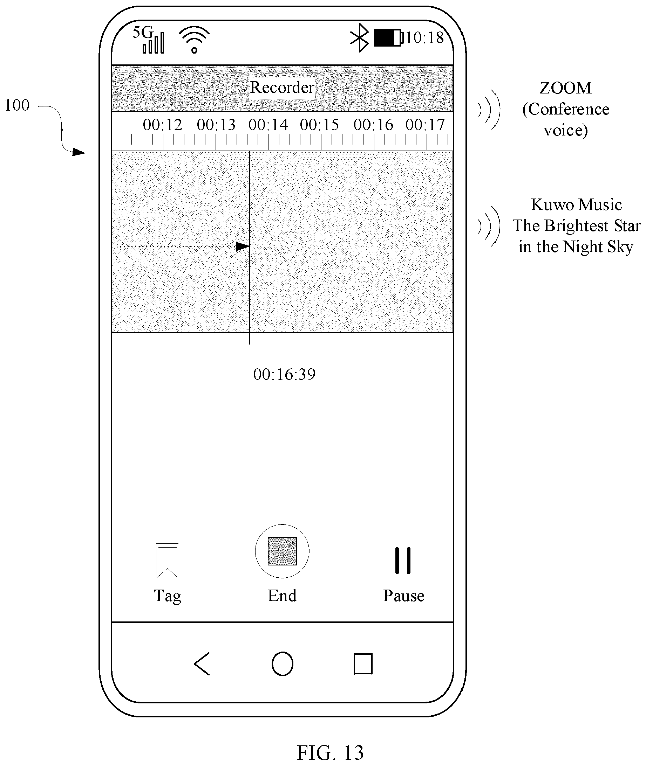

This embodiment is used to provide a media file recording method. FIG. 13 shows an example application scenario of this embodiment. In FIG. 13, the electronic device 100 is outputting audio of Kuwo Music and audio of ZOOM. An audio recording application (which is a recorder application in this embodiment) further runs on the electronic device 100. The recorder may record audio that is being output by the electronic device 100.

In a conventional technology, the recorder records all pieces of audio (overlaid audio of various pieces of audio) that is being output by the electronic device 100. For example, when the electronic device 100 is outputting audio of Kuwo music and audio of ZOOM, the recorder records overlaid audio of the audio of Kuwo music and the audio of ZOOM. However, sometimes, a user wants to record only audio of a specific application, for example, the user wants to record only audio of ZOOM. The conventional technology cannot meet this requirement of the user.

Therefore, this embodiment provides an audio file (used as a media file) recording method. When an electronic device 100 outputs audio of a plurality of audio applications (referred to as "candidate applications"), the electronic device 100 records only audio of a selected application (referred to as a "target application"), and does not record audio of a candidate application other than the target application. This meets diversified requirements of the user.

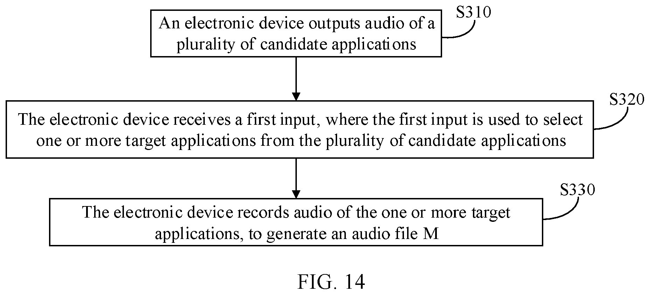

The following describes the technical solution of this embodiment in detail with reference to FIG. 14. As shown in FIG. 14, the audio recording method in this embodiment includes the following steps:

S310: The electronic device 100 outputs audio of a plurality of candidate applications.

In this embodiment, the electronic device 100 outputs audios of two candidate applications (specifically, Kuwo Music and ZOOM). In another embodiment, the electronic device 100 may output audio of another quantity (for example, four) of candidate applications. In addition, the candidate application may be an application other than Kuwo Music and ZOOM, for example, iQIYI or Baidu Maps, provided that the application can output audio.

In addition, that the electronic device 100 outputs audio of a plurality of candidate applications may include: the electronic device 100 plays the audio of the candidate applications through an audio playback apparatus (for example, a speaker) of the electronic device 100, and/or the electronic device 100 plays the audio of the candidate applications through another audio playback device (for example, a Bluetooth headset or a smartwatch).

S320: The electronic device 100 receives a first input, where the first input is used to select one or more target applications from the plurality of candidate applications.

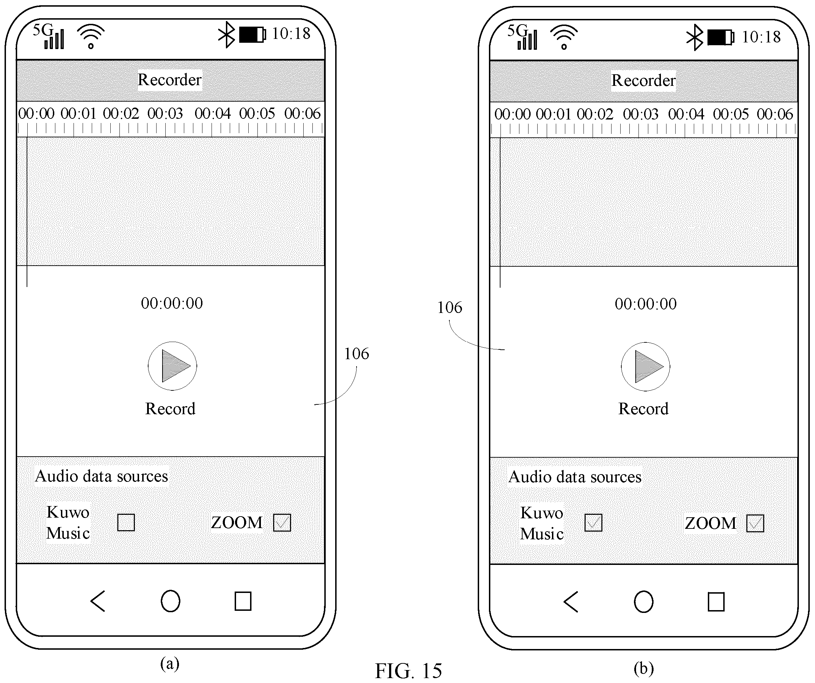

In this embodiment, the first input is a screen input from the user. FIG. 15 shows an example of a screen input. Specifically, after the user taps an application icon of the recorder, an interface 106 of the recorder application shown in FIG. 15 is displayed. The interface 106 includes a "record" button and check boxes corresponding to the candidate applications. The user may select, through the check box, a target application whose audio is expected to be recorded.

Refer to (a) in FIG. 15. After the user ticks a check box of ZOOM, the electronic device 100 determines ZOOM as the target application. It may be understood that, in the example provided in (a) in FIG. 15, a quantity of target applications is less than a quantity of candidate applications.

Refer to (b) in FIG. 15. After the user ticks check boxes of both Kuwo Music and ZOOM, the electronic device 100 determines both Kuwo Music and ZOOM as target applications.

The foregoing is an example description of a manner of selecting a target application, and a person skilled in the art may make other variations. For example, in another embodiment, the quantity of target applications may be another quantity, for example, 4. For another example, in another embodiment, the user selects a target application by using a voice instruction (that is, the first input is a voice input of the user).

S330: The electronic device 100 records audio of the one or more target applications, to generate an audio file A (as an example of a first media file).

In (a) in FIG. 15, the user selects ZOOM as the target application. In this way, after the user taps the "record" button on the interface 106, the recorder application starts to obtain audio stream data of ZOOM (that is, starts to record audio of ZOOM), and generates the audio file A by using the audio stream data of ZOOM. In other words, in the example shown in (a) in FIG. 15, audio data in the audio file A is audio data (denoted as Record_Data_1) of ZOOM.

In (b) in FIG. 15, the user selects both Kuwo Music and ZOOM as target applications. In this way, after the user taps the "record" button on the interface 106, the recorder application starts to obtain audio stream data obtained by performing audio mixing on audio of ZOOM and Kuwo music (that is, starts to record audio of Kuwo music and audio of ZOOM), and generates the audio file A by using the audio stream data obtained by audio mixing. In other words, in the example shown in (b) in FIG. 15, audio data in the audio file A is overlaid audio data of the audio of Kuwo Music (whose audio data is Record_Data_2) and the audio of ZOOM (whose audio data is Record_Data_1), and is specifically Record_Data_1+Record_Data_2.

In this embodiment, when the electronic device 100 outputs audio of a plurality of candidate applications at the same time, the electronic device 100 may record only audio of a target application. This meets diversified requirements of the user. For example, as shown in (a) in FIG. 15, when the electronic device 100 outputs the audio of Kuwo music and the audio of the ZOOM, if the user wants to record only the audio of ZOOM, and does not want to record the audio of Kuwo music, the user may select the target application in the manner shown in (a) in FIG. 15. In this way, after the electronic device 100 completes recording, the audio file A includes only the audio of ZOOM, but does not include the audio of Kuwo music.

It should be noted that this embodiment is an example of description of the technical solutions of this application, and a person skilled in the art may make other variations.

For example, in another embodiment, the electronic device 100 further outputs video data of a first video application while outputting the audio data of the plurality of candidate applications. The first video application may be one of the plurality of candidate applications, or may be an application other than the plurality of candidate applications.

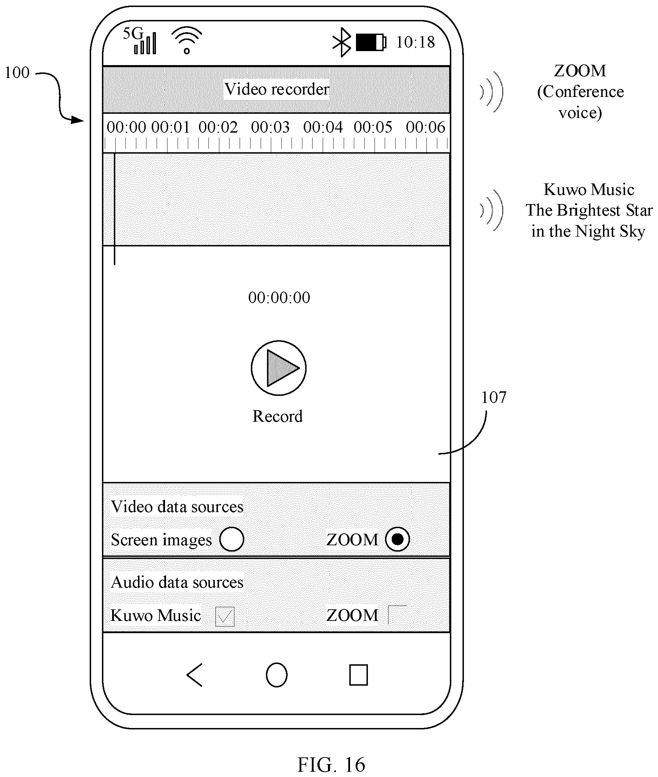

The following describes this embodiment with reference to a scenario shown in FIG. 16. In FIG. 16, the electronic device 100 is running Kuwo Music and ZOOM. Kuwo Music and ZOOM are used as examples of a plurality of candidate applications (applications that are outputting audio on the electronic device 100), and ZOOM is used as an example of the first video application (video data of ZOOM is real-time image data of a call). In other words, in this example, the first video application is one of the plurality of candidate applications. In addition, the electronic device 100 further runs a video recorder application. FIG. 16 shows a home page 107 of the video recorder application.

Refer to FIG. 16. The home page 107 of the video recorder application includes two video data source options (referred to as "video options"), which are respectively a screen image and a video application (specifically "ZOOM") currently running on the electronic device 100. The page 107 further includes radio buttons corresponding to the two video options. The user may select one of the video options as a video data source of the video recorder application through the radio button. According to FIG. 16, the video data source of the video recorder application is ZOOM.

The home page 107 of the video recorder application further includes two audio data source options (referred to as "audio options"), which are respectively two audio applications (namely, the candidate applications, which are specifically Kuwo Music and ZOOM) currently running on the electronic device 100. The page 107 further includes check boxes corresponding to the two audio options. The user may select one or more candidate applications (a selected candidate application is the target application) as audio data sources of the video recorder application through the check boxes. According to FIG. 16, the audio data source of the video recorder application is Kuwo Music. In other words, the target application is Kuwo Music in FIG. 16.

After the user taps a "record" button, the video recorder application starts to obtain video stream data of ZOOM (that is, start recording a video of ZOOM), synchronously obtains audio stream data of Kuwo Music (that is, start recording audio of Kuwo Music), and synthesizes the video stream data of ZOOM and the audio stream data of Kuwo Music into a video file B (as an example of the first media file). In other words, in the example shown in FIG. 16, video data in the video file B is the video data of ZOOM, and audio data in the video file B is the audio data of Kuwo Music.

It may be understood that, in another example, if the user ticks both Kuwo Music and ZOOM in the audio options on the page 107, audio data in the video file B recorded by the video recorder application is overlaid audio data of the audio of Kuwo Music and the audio of ZOOM.

According to the embodiment provided in FIG. 16, in the case of video recording, the user may select the video data source and the audio data source. This meets diversified requirements of the user. For example, according to the embodiment provided in FIG. 16, the user may use the audio of Kuwo Music as background audio of a ZOOM call image, thereby adding a sense of fun.

It should be noted that the scenario shown in FIG. 16 is merely an example application scenario of the technical solutions of this application, and a person skilled in the art may make other variations. For example, the audio application may be an application other than Kuwo Music and ZOOM, and the first video application may be an application other than the audio application.

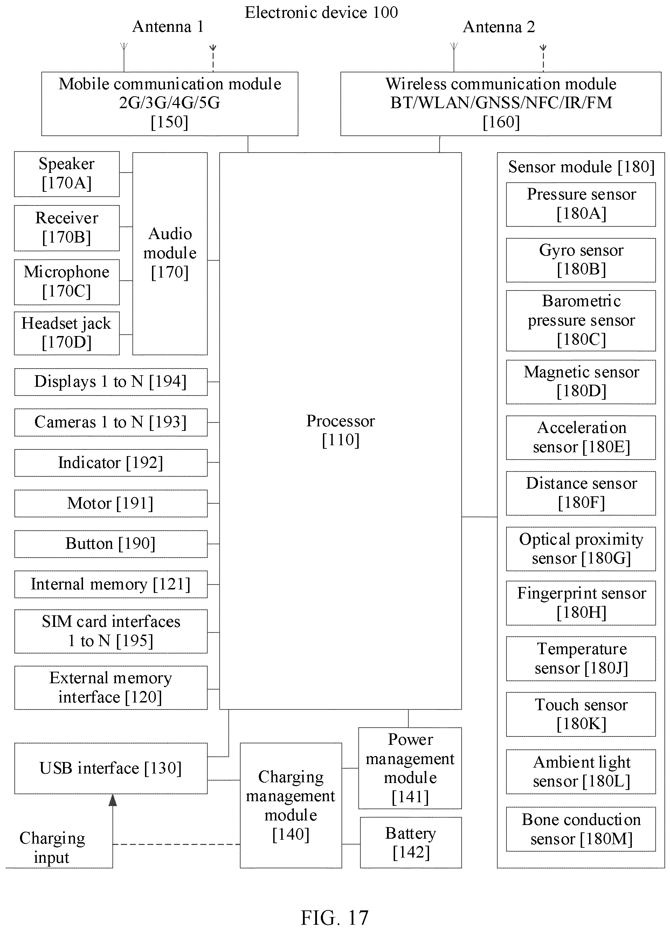

FIG. 17 is a schematic diagram of a structure of the electronic device 100. The electronic device 100 may include a processor 110, an external memory interface 120, an internal memory 121, a universal serial bus (universal serial bus, USB) interface 130, a charging management module 140, a power management module 141, a battery 142, an antenna 1, an antenna 2, a mobile communication module 150, a wireless communication module 160, an audio module 170, a speaker 170A, a receiver 170B, a microphone 170C, a headset jack 170D, a sensor module 180, a button 190, a motor 191, an indicator 192, a camera 193, a display 194, a subscriber identity module (subscriber identification module, SIM) card interface 195, and the like. The sensor module 180 may include a pressure sensor 180A, a gyro sensor 180B, a barometric pressure sensor 180C, a magnetic sensor 180D, an acceleration sensor 180E, a distance sensor 180F, an optical proximity sensor 180G, a fingerprint sensor 180H, a temperature sensor 180J, a touch sensor 180K, an ambient light sensor 180L, a bone conduction sensor 180M, and the like.

It may be understood that the structure shown in this embodiment of the present invention does not constitute a specific limitation on the electronic device 100. In some other embodiments of this application, the electronic device 100 may include more or fewer components than those shown in the figure, or some components may be combined, or some components may be split, or different component arrangements may be used. The components shown in the figure may be implemented by hardware, software, or a combination of software and hardware.

The processor 110 may include one or more processing units. For example, the processor 110 may include an application processor (application processor, AP), a modem processor, a graphics processing unit (graphics processing unit, GPU), an image signal processor (image signal processor, ISP), a controller, a video codec, a digital signal processor (digital signal processor, DSP), a baseband processor, a neural-network processing unit (neural-network processing unit, NPU), and/or the like. Different processing units may be independent components, or may be integrated into one or more processors.

The processor may generate an operation control signal based on instruction operation code and a timing signal to complete control of instruction fetching and instruction execution.

The processor 110 may be further provided with a memory for storing instructions and data. In some embodiments, the memory in the processor 110 is a cache memory. The memory may store instructions or data just used or repeatedly used by the processor 110. If the processor 110 needs to use the instructions or data again, the processor 110 may directly invoke the instructions or data from the memory. This avoids repeated access and reduces a waiting time of the processor 110, and therefore improves efficiency of a system.

In some embodiments, the processor 110 may include one or more interfaces. The interface may include an inter-integrated circuit (inter-integrated circuit, I2C) interface, an inter-integrated circuit sound (inter-integrated circuit sound, I2S) interface, a pulse code modulation (pulse code modulation, PCM) interface, a universal asynchronous receiver/transmitter (universal asynchronous receiver/transmitter, UART) interface, a mobile industry processor interface (mobile industry processor interface, MIPI), a general-purpose input/output (general-purpose input/output, GPIO) interface, or a subscriber identity module (subscriber identity module, SIM) interface.

The I2C interface is a bidirectional synchronous serial bus and includes a serial data line (serial data line, SDA) and a serial clock line (derail clock line, SCL). In some embodiments, the processor 110 may include a plurality of groups of I2C buses. The processor 110 may be coupled to the touch sensor 180K, a charger, a flash, the camera 193, and the like through different I2C bus interfaces. For example, the processor 110 may be coupled to the touch sensor 180K through the I2C interface, so that the processor 110 communicates with the touch sensor 180K through the I2C bus interface, to implement a touch function of the electronic device 100.

The I2S interface may be used for audio communication. In some embodiments, the processor 110 may include a plurality of groups of I2S buses. The processor 110 may be coupled to the audio module 170 through the I2S bus, to implement communication between the processor 110 and the audio module 170. In some embodiments, the audio module 170 may transmit an audio signal to the wireless communication module 160 through the I2S interface, to implement a function of answering a call through a Bluetooth headset.

The PCM interface may also be used for audio communication to sample, quantize, and encode an analog signal. In some embodiments, the audio module 170 may be coupled to the wireless communication module 160 through a PCM bus interface. In some embodiments, the audio module 170 may alternatively transmit an audio signal to the wireless communication module 160 through the PCM interface, to implement a function of answering a call through a Bluetooth headset. Both the I2S interface and the PCM interface may be used for audio communication.

The UART interface is a universal serial data bus used for asynchronous communication. The bus may be a bidirectional communication bus that converts to-be-transmitted data between serial communication and parallel communication. In some embodiments, the UART interface is usually configured to connect the processor 110 to the wireless communication module 160. For example, the processor 110 communicates with a Bluetooth module in the wireless communication module 160 through the UART interface, to implement a Bluetooth function. In some embodiments, the audio module 170 may transmit an audio signal to the wireless communication module 160 through the UART interface, to implement a function of playing music through a Bluetooth headset.

The MIPI interface may be configured to connect the processor 110 to a peripheral component such as the display 194 or the camera 193. The MIPI interface includes a camera serial interface (camera serial interface, CSI), a display serial interface (display serial interface, DSI), and the like. In some embodiments, the processor 110 communicates with the camera 193 through the CSI interface, to implement a photographing function of the electronic device 100. The processor 110 communicates with the display 194 through the DSI interface, to implement a display function of the electronic device 100.

The GPIO interface may be configured by using software. The GPIO interface may be configured as a control signal or a data signal. In some embodiments, the GPIO interface may be configured to connect the processor 110 to the camera 193, the display 194, the wireless communication module 160, the audio module 170, the sensor module 180, or the like. The GPIO interface may alternatively be configured as an I2C interface, an I2S interface, a UART interface, an MIPI interface, or the like.

It may be understood that an interface connection relationship between the modules shown in this embodiment of the present invention is merely an example for description, and does not constitute a limitation on a structure of the electronic device 100. In some other embodiments of this application, the electronic device 100 may alternatively use an interface connection manner different from that in the foregoing embodiment, or use a combination of a plurality of interface connection manners.

The USB interface 130 is a connector that complies with a USB standard specification, and may be configured to connect the electronic device 100 and a peripheral device, and may be specifically a standard USB interface (for example, a Type C interface), a Mini USB interface, a Micro USB interface, or the like. The USB interface 130 may be configured to connect to a charger to charge the electronic device 100, or may be configured to transmit data between the electronic device 100 and the peripheral device, or may be configured to connect to a headset to play audio through the headset. Alternatively, the interface may be configured to connect to another electronic device, for example, an AR device. In some implementation solutions, the processor 110 may support a universal serial bus (Universal Serial Bus), and a standard specification of the universal serial bus may be USB 1.x, USB 2.0, USB 3.x, or USB 4.

The charging management module 140 is configured to receive a charging input from the charger. The charger may be a wireless charger or a wired charger. In some embodiments of wired charging, the charging management module 140 may receive a charging input of a wired charger through the USB interface 130. In some embodiments of wireless charging, the charging management module 140 may receive a wireless charging input through a wireless charging coil of the electronic device 100. The charging management module 140 may further supply power to the electronic device by using the power management module 141 while charging the battery 142.

The power management module 141 is configured to connect to the battery 142, the charging management module 140, and the processor 110. The power management module 141 receives an input from the battery 142 and/or the charging management module 140, and supplies power to the processor 110, the internal memory 121, the display 194, the camera 193, the wireless communication module 160, and the like. The power management module 141 may be further configured to monitor a parameter such as a battery capacity, a quantity of battery cycles, and a battery health status (electric leakage or impedance). In some other embodiments, the power management module 141 may alternatively be disposed in the processor 110. In some other embodiments, the power management module 141 and the charging management module 140 may alternatively be disposed in a same device.

A wireless communication function of the electronic device 100 may be implemented by using the antenna 1, the antenna 2, the mobile communication module 150, the wireless communication module 160, the modem processor, the baseband processor, and the like.

The antenna 1 and the antenna 2 are configured to transmit and receive an electromagnetic wave signal. Each antenna in the electronic device 100 may be configured to cover one or more communication frequency bands. Different antennas may be further reused to improve antenna utilization. For example, the antenna 1 may be reused as a diversity antenna of a wireless local area network. In some other embodiments, the antenna may be used in combination with a tuning switch.

The mobile communication module 150 may provide a solution applied to the electronic device 100 for wireless communication such as 2G/3G/4G/5G. The mobile communication module 150 may include at least one filter, a switch, a power amplifier, a low noise amplifier (low noise amplifier, LNA), and the like. The mobile communication module 150 may receive an electromagnetic wave through the antenna 1, perform processing such as filtering and amplification on the received electromagnetic wave, and transmit a processed electromagnetic wave to the modem processor for demodulation. The mobile communication module 150 may further amplify a signal modulated by the modem processor, and convert the signal into an electromagnetic wave for radiation through the antenna 1. In some embodiments, at least some functional modules in the mobile communication module 150 may be disposed in the processor 110. In some embodiments, at least some functional modules in the mobile communication module 150 may be disposed in a same device as at least some modules in the processor 110.

The modem processor may include a modulator and a demodulator. The modulator is configured to modulate a to-be-sent low-frequency baseband signal into a medium-high frequency signal. The demodulator is configured to demodulate the received electromagnetic wave signal into a low-frequency baseband signal. Then, the demodulator transmits the low-frequency baseband signal obtained through demodulation to the baseband processor for processing. The low-frequency baseband signal is processed by the baseband processor and then transmitted to the application processor. The application processor outputs a sound signal through an audio device (which is not limited to the speaker 170A, the receiver 170B, or the like), or displays an image or a video through the display 194. In some embodiments, the modem processor may be an independent component. In some other embodiments, the modem processor may be independent of the processor 110, and is disposed in a same device as the mobile communication module 150 or another function module.

The wireless communication module 160 may provide a wireless communication solution that is applied to the electronic device 100, and that includes a wireless local area network (wireless local area network, WLAN) (for example, a wireless fidelity (wireless fidelity, Wi-Fi) network), Bluetooth (Bluetooth, BT), a global navigation satellite system (global navigation satellite system, GNSS), frequency modulation (frequency modulation, FM), a near field communication (near field communication, NFC) technology, an infrared (infrared, IR) technology, or the like. The wireless communication module 160 may be one or more components integrating at least one communication processor module. The wireless communication module 160 receives an electromagnetic wave through the antenna 2, performs frequency modulation and filtering processing on an electromagnetic wave signal, and sends a processed signal to the processor 110. The wireless communication module 160 may further receive a to-be-sent signal from the processor 110, perform frequency modulation and amplification on the signal, and convert a processed signal into an electromagnetic wave for radiation through the antenna 2.

In some embodiments, the antenna 1 of the electronic device 100 is coupled to the mobile communication module 150, and the antenna 2 is coupled to the wireless communication module 160, so that the electronic device 100 may communicate with a network and another device by using a wireless communication technology. The wireless communication technology may include a global system for mobile communications (global system for mobile communications, GSM), a general packet radio service (general packet radio service, GPRS), code division multiple access (code division multiple access, CDMA), wideband code division multiple access (wideband code division multiple access, WCDMA), time-division code division multiple access (time-division code division multiple access, TD-SCDMA), long term evolution (long term evolution, LTE), the BT, the GNSS, the WLAN, the NFC, the FM, the IR technology, and/or the like. The GNSS may include a global positioning system (global positioning system, GPS), a global navigation satellite system (global navigation satellite system, GLONASS), a BeiDou navigation satellite system (BeiDou navigation satellite system, BDS), a quasi-zenith satellite system (quasi-zenith satellite system, QZSS), and/or a satellite based augmentation system (satellite based augmentation systems, SBAS).

The electronic device 100 implements a display function through the GPU, the display 194, the application processor, and the like. The GPU is a microprocessor for image processing, and is connected to the display 194 and the application processor. The GPU is configured to perform mathematical and geometric calculation and render graphics. The processor 110 may include one or more GPUs that execute program instructions to generate or change display information.

The display 194 is configured to display an image, a video, or the like. The display 194 includes a display panel. The display panel may use a liquid crystal display (liquid crystal display, LCD), an organic light-emitting diode (organic light-emitting diode, OLED), an active-matrix organic light emitting diode (active-matrix organic light emitting diode, AMOLED), a flexible light-emitting diode (flex light-emitting diode, FLED), a mini-LED, a micro-LED, a micro-OLED, a quantum dot light emitting diode (quantum dot light emitting diode, QLED), or the like. In some embodiments, the electronic device 100 may include one or N displays 194, where N is a positive integer greater than 1.

The electronic device 100 may implement a photographing function through the ISP, the camera 193, the video codec, the GPU, the display 194, the application processor, and the like.

The ISP is configured to process data fed back by the camera 193. For example, when a shutter is opened for taking a photo, light is transmitted to a photosensitive element of the camera through a lens so that a light signal is converted into an electrical signal. The photosensitive element of the camera transmits the electrical signal to the ISP for processing, so that the electrical signal is converted into an image visible to eyes. The ISP may also optimize noise, brightness, and skin tone of the image by using algorithms. The ISP may also optimize parameters such as exposure and a color temperature of a photographing scene. In some embodiments, the ISP may be disposed in the camera 193.

The camera 193 is configured to capture a static image or a video. An optical image of an object is generated by using the lens and is projected to the photosensitive element. The photosensitive element may be a charge coupled device (charge coupled device, CCD) or a complementary metal-oxide-semiconductor (complementary metal-oxide-semiconductor, CMOS) phototransistor. The photosensitive element converts an optical signal into an electrical signal, and then transfers the electrical signal to the ISP to convert the electrical signal into a digital image signal. The ISP outputs the digital image signal to the DSP for processing. The DSP converts the digital image signal into an image signal in a standard format such as RGB or YUV. In some embodiments, the electronic device 100 may include one or N cameras 193, where N is a positive integer greater than 1.

The digital signal processor is configured to process digital signals, including a digital image signal and another digital signal. For example, when the electronic device 100 selects a frequency, the digital signal processor is configured to perform Fourier transform on frequency energy.

The video codec is configured to compress or decompress a digital video. The electronic device 100 may support one or more types of video codecs. In this way, the electronic device 100 can play or record videos in a plurality of coding formats, such as moving picture experts group (moving picture experts group, MPEG)-1, MPEG-2, MPEG-3, and MPEG-4.

The NPU is a neural-network (neural-network, NN) computing processor that fast processes input information with reference to a structure of a biological neural network structure, for example, a transfer mode between human brain neurons, and can further perform continuous self-learning. Applications such as intelligent cognition of the electronic device 100, for example, image recognition, facial recognition, voice recognition, and text understanding may be implemented through the NPU.

The external memory interface 120 may be configured to connect to an external memory card, for example, a micro SD card, to extend a storage capability of the electronic device 100. The external memory card communicates with the processor 110 through the external memory interface 120, to implement a data storage function. For example, files such as music and videos are stored in the external memory card.

The internal memory 121 may be configured to store computer-executable program code. The executable program code includes instructions. The internal memory 121 may include a program storage area and a data storage area. The program storage area may store an operating system, an application program required by at least one function (such as a sound playing function or an image playing function), and the like. The data storage area may store data (for example, audio data and an address book) created during use of the electronic device 100, and the like. In addition, the internal memory 121 may include a high-speed random access memory, and may further include a nonvolatile memory, for example, at least one magnetic disk storage device, a flash storage device, and a universal flash storage (universal flash storage, UFS). The processor 110 runs the instructions stored in the internal memory 121 and/or instructions stored in the memory disposed in the processor, to perform various function applications and data processing of the electronic device 100. The instructions stored in the memory 121 may include instructions that, when executed by at least one of the processors, cause the electronic device 100 to implement the audio output method and/or the media file recording method provided by embodiments of this application.

The electronic device 100 may implement an audio function, for example, music playback and recording through the audio module 170, the speaker 170A, the receiver 170B, the microphone 170C, the headset jack 170D, the application processor, and the like.

The audio module 170 is configured to convert digital audio information into an analog audio signal for output, and is also configured to convert analog audio input into a digital audio signal. The audio module 170 may be further configured to encode and decode an audio signal. In some embodiments, the audio module 170 may be disposed in the processor 110, or some functional modules in the audio module 170 are disposed in the processor 110.

The speaker 170A, also referred to as a "loudspeaker", is configured to convert an audio electrical signal into a sound signal. The electronic device 100 may be used for listening to music or answering a hands-free call through the speaker 170A.

The receiver 170B, also referred to as an "earpiece", is configured to convert an audio electrical signal into a sound signal. When the electronic device 100 receives a call or a voice message, the receiver 170B may be placed near a human ear for listening to a voice.

The microphone 170C, also referred to as a "mike" or "mic", is configured to convert a sound signal into an electrical signal. When making a call or sending voice information, a user may make a sound by moving a human mouth close to the microphone 170C to input a sound signal to the microphone 170C. At least one microphone 170C may be disposed in the electronic device 100. In some other embodiments, two microphones 170C may be disposed in the electronic device 100, to collect a sound signal and implement a noise reduction function. In some other embodiments, three, four, or more microphones 170C may alternatively be disposed in the electronic device 100, to collect a sound signal, implement noise reduction, and identify a sound source, so as to implement a directional recording function and the like.

The headset jack 170D is configured to connect to a wired headset. The headset jack 170D may be the USB interface 130, or may be a 3.5 mm open mobile terminal platform (open mobile terminal platform, OMTP) standard interface or a cellular telecommunications industry association of the USA (cellular telecommunications industry association of the USA, CTIA) standard interface.

The pressure sensor 180A is configured to sense a pressure signal, and can convert the pressure signal into an electrical signal. In some embodiments, the pressure sensor 180A may be disposed on the display 194. There are many types of pressure sensor 180A,
such as a resistive pressure sensor, an inductive pressure sensor, and a capacitive pressure sensor. The capacitive pressure sensor may include at least two parallel plates made of conductive materials. When a force is applied to the pressure sensor 180A, capacitance between electrodes changes. The electronic device 100 determines pressure intensity based on the change in the capacitance. When a touch operation is performed on the display 194, the electronic device 100 detects intensity of the touch operation through the pressure sensor 180A. The electronic device 100 may further calculate a touch position based on a detection signal of the pressure sensor 180A. In some embodiments, touch operations that are performed in a same touch position but have different touch operation intensity may correspond to different operation instructions. For example, when a touch operation whose touch operation intensity is less than a first pressure threshold is performed on an SMS message application icon, an instruction for viewing an SMS message is performed. When a touch operation whose touch operation intensity is greater than or equal to the first pressure threshold is performed on the SMS message application icon, an instruction for creating a new SMS message is performed.

The gyro sensor 180B may be configured to determine a motion posture of the electronic device 100. In some embodiments, angular velocities of the electronic device 100 around three axes (namely, X, Y, and z axes) may be determined by using the gyro sensor 180B. The gyro sensor 180B may be configured to implement image stabilization during photographing. For example, when the shutter is opened, the gyro sensor 180B detects a shaking angle of the electronic device 100, and calculates, based on the angle, a distance for which a lens module needs to compensate, so that the lens can move reversely to counteract the shaking of the electronic device 100, so as to implement image stabilization. The gyro sensor 180B may be further used for navigation and somatosensory game scenarios.

The barometric pressure sensor 180C is configured to measure barometric pressure. In some embodiments, the electronic device 100 calculates an altitude based on a barometric pressure value measured by the barometric pressure sensor 180C to assist positioning and navigation.

The magnetic sensor 180D includes a Hall effect sensor. The electronic device 100 may detect opening and closing of a flip leather case by using the magnetic sensor 180D. In some embodiments, when the electronic device 100 is a clamshell phone, the electronic device 100 may detect opening and closing of a flip cover by using the magnetic sensor 180D. Further, a feature such as automatic unlocking of the flip cover is set based on a detected opening or closing state of the leather case or a detected opening or closing state of the flip cover.

The acceleration sensor 180E may detect accelerations in various directions (usually on three axes) of the electronic device 100. When the electronic device 100 is still, a magnitude and a direction of gravity may be detected. The acceleration sensor 180E may be further configured to identify a posture of the electronic device, and is used in an application such as switching between a landscape mode and a portrait mode or a pedometer.

The distance sensor 180F is configured to measure a distance. The electronic device 100 may measure a distance by using infrared or a laser. In some embodiments, the electronic device 100 may measure a distance by using the distance sensor 180F in a photographing scenario, to implement quick focusing.

The optical proximity sensor 180G may include, for example, a light emitting diode (LED) and an optical detector, for example, a photodiode. The light-emitting diode may be an infrared light-emitting diode. The electronic device 100 emits infrared light by using the light-emitting diode. The electronic device 100 detects infrared reflected light from a nearby object through the photodiode. When sufficient reflected light is detected, it may be determined that there is an object near the electronic device 100. When insufficient reflected light is detected, the electronic device 100 may determine that there is no object near the electronic device 100. The electronic device 100 may detect, by using the optical proximity sensor 180G, that a user is holding the electronic device 100 close to an ear for a call, to automatically perform screen-off for power saving. The optical proximity sensor 180G may alternatively be used in a leather case mode or a pocket mode to automatically unlock or lock a screen.

The ambient light sensor 180L is configured to sense brightness of ambient light. The electronic device 100 may adaptively adjust brightness of the display 194 based on the sensed brightness of ambient light. The ambient light sensor 180L may be further configured to automatically adjust white balance during photographing. The ambient light sensor 180L may further cooperate with the optical proximity sensor 180G in detecting whether the electronic device 100 is in a pocket, to prevent an accidental touch.

The fingerprint sensor 180H is configured to collect a fingerprint. The electronic device 100 may use a feature of the collected fingerprint to implement fingerprint-based unlocking, application lock access, fingerprint-based photographing, fingerprint-based call answering, and the like.

The temperature sensor 180J is configured to detect a temperature. In some embodiments, the electronic device 100 executes a temperature processing policy based on the temperature detected by the temperature sensor 180J. For example, when the temperature reported by the temperature sensor 180J exceeds a threshold, the electronic device 100 lowers performance of a processor near the temperature sensor 180J, to reduce power consumption for thermal protection. In some other embodiments, when the temperature is less than another threshold, the electronic device 100 heats the battery 142 to avoid abnormal shutdown of the electronic device 100 caused by a low temperature. In some other embodiments, when the temperature is less than still another threshold, the electronic device 100 boosts an output voltage of the battery 142, to avoid abnormal shutdown caused by a low temperature.

The touch sensor 180K is also referred to as a "touch device". The touch sensor 180K may be disposed on the display 194. The touch sensor 180K and the display 194 constitute a touchscreen, which is also referred to as a "touch screen". The touch sensor 180K is configured to detect a touch operation performed on or near the touch sensor 180K. The touch sensor may transfer the detected touch operation to the application processor to determine a type of the touch event. A visual output related to the touch operation may be provided on the display 194. In some other embodiments, the touch sensor 180K may alternatively be disposed on a surface of the electronic device 100 at a position different from that of the display 194.

The bone conduction sensor 180M may obtain a vibration signal. In some embodiments, the bone conduction sensor 180M may obtain a vibration signal of a vibration bone of a human vocal-cord part. The bone conduction sensor 180M may also be in contact with a human pulse, to receive a blood pressure beating signal. In some embodiments, the bone conduction sensor 180M may alternatively be disposed in the headset, to obtain a bone conduction headset. The audio module 170 may obtain a voice signal through parsing based on the vibration signal, of the vibration bone of the vocal-cord part, obtained by the bone conduction sensor 180M, to implement a voice function. The application processor may parse heart rate information based on the blood pressure beating signal obtained by the bone conduction sensor 180M, to implement a heart rate detection function.

The button 190 includes a power button, a volume button, and the like. The button 190 may be a mechanical button, or may be a touch button. The electronic device 100 may receive a button input, and generate a button signal input related to a user setting and function control of the electronic device 100.

The motor 191 may generate a vibration prompt. The motor 191 may be configured to provide a vibration alert for an incoming call, and may also be configured to provide a vibration feedback for a touch. For example, touch operations performed on different applications (for example, photographing and audio playback) may correspond to different vibration feedback effects. The motor 191 may also correspond to different vibration feedback effects for touch operations performed on different areas of the display 194. Different application scenarios (for example, a time reminder, information receiving, an alarm, and a game) may also correspond to different vibration feedback effects. In addition, a touch vibration feedback effect may be userdefined.

The indicator 192 may be an indicator light, and may be configured to indicate a charging status and a power change, or may be configured to indicate a message, a missed call, a notification, and the like.

The SIM card interface 195 is configured to connect to a SIM card. The SIM card may be inserted into the SIM card interface 195 or removed from the SIM card interface 195, to implement contact with or separation from the electronic device 100. The electronic device 100 may support one or N SIM card interfaces, where N is a positive integer greater than 1. The SIM card interface 195 may support a nano-SIM card, a micro-SIM card, a SIM card, and the like. A plurality of cards may be inserted into one SIM card interface 195 at the same time. The plurality of cards may be of a same type or different types. The SIM card interface 195 may be compatible with different types of SIM cards. The SIM card interface 195 may also be compatible with an external memory card. The electronic device 100 interacts with a network through the SIM card, to implement functions such as making/answering a call and data communication. In some embodiments, the electronic device 100 uses an eSIM, that is, an embedded SIM card. The eSIM card may be embedded in the electronic device 100, and cannot be separated from the electronic device 100.

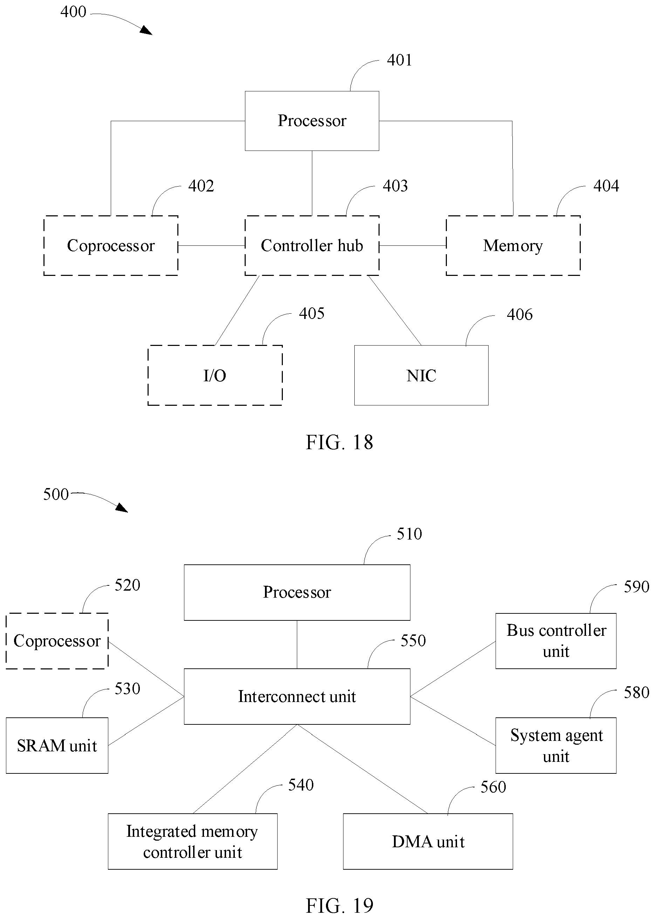

FIG. 18 is a block diagram of an electronic device 400 according to an embodiment of this application. The electronic device 400 may include one or more processors 401 coupled to a controller hub 403. For at least one embodiment, the controller hub 403 communicates with a processor 401 through a multi-branch bus such as a front side bus (Front Side Bus, FSB), a point-to-point interface such as a quick path interconnect (Quick Path Interconnect, QPI) interface, or a similar connection 406. The processor 401 executes instructions for controlling a general type of data processing operation. In an embodiment, the controller hub 403 includes, but is not limited to, a graphics and memory controller hub (Graphics & Memory Controller Hub, GMCH) (not shown) and an input/output hub (Input Output Hub, IOH) (which may be on a separate chip) (not shown). The GMCH includes a memory and a graphics controller, and is coupled to the IOH.

The electronic device 400 may further include a coprocessor 402 and a memory 404 that are coupled to the controller hub 403. Alternatively, one or both of the memory and the GMCH may be integrated into the processor (as described in this application). The memory 404 and the coprocessor 402 are directly coupled to the processor 401 and the controller hub 403. The controller hub 403 and the IOH are located in a single chip.

The memory 404 may be, for example, a dynamic random access memory (Dynamic Random Access Memory, DRAM), a phase change memory (Phase Change Memory, PCM), or a combination of both. The memory 404 may include one or more tangible and non-transitory computer-readable media that are configured to store data and/or instructions. The computer-readable storage medium stores instructions, and specifically, stores temporary and permanent copies of the instructions.

The instructions stored in the memory 404 may include instructions, when executed by at least one of the processors, cause the electronic device to implement the methods shown in FIG. 4a, FIG. 5b, FIG. 8, FIG. 9, FIG. 12a, and FIG. 14.

In an embodiment, the coprocessor 402 is a dedicated processor, for example, a highthroughput many integrated core (Many Integrated Core, MIC) processor, a network or communication processor, a compression engine, a graphics processor, general-purpose computing on graphics processing units (General-purpose computing on graphics processing units, GPGPU), or an embedded processor. An optional property of the coprocessor 402 is shown in FIG. 18 by using dashed lines.

In an embodiment, the electronic device 400 may further include a network interface (Network Interface Controller, NIC) 406. The network interface 406 may include a transceiver, configured to provide a radio interface for the electronic device 400, to communicate with any another suitable device (such as a front-end module or an antenna). In various embodiments, the network interface 406 may be integrated with another component of the electronic device 400. The network interface 406 may implement a function of the communication unit in the foregoing embodiment.

The electronic device 400 may further include an input/output (Input/Output, I/O) device 405. The I/O 405 may include: a user interface, where this design enables a user to interact with the electronic device 400; a peripheral component interface, where this design enables the peripheral component to interact with the electronic device 400; and/or a sensor, where the sensor is configured to determine an environmental condition and/or location information related to the electronic device 400.

It should be noted that FIG. 18 is merely an example. To be specific, although FIG. 18 shows that the electronic device 400 includes a plurality of components such as the processor 401, the controller hub 403, and the memory 404, in actual application, a device using the methods in this application may include only some of the components of the electronic device 400, for example, may include only the processor 401 and the network interface 406. Properties of optional components are shown in FIG. 18 by using dashed lines.

FIG. 19 is a block diagram of a system on chip (System on Chip, SoC) 500 according to an embodiment of this application. Similar components have a same reference numeral in FIG. 19. In addition, a dashed-line box is an optional feature of a more advanced SoC. In FIG. 19, the SoC 500 includes: an interconnect unit 550, coupled to a processor 510; a system agent unit 580; a bus controller unit 590; an integrated memory controller unit 540; one group of or one or more coprocessors 520 that may include integrated graphics logic, an image processor, an audio processor, and a video processor; a static random access memory (Static Random Access Memory, SRAM) unit 530; and a direct memory access (Direct Memory Access, DMA) unit 560. In an embodiment, the coprocessor 520 includes a dedicated processor, for example, a network or communication processor, a compression engine, general-purpose computing on graphics processing units (General-purpose computing on graphics processing units, GPGPU), a highthroughput MIC processor, or an embedded processor.

The static random access memory unit 530 may include one or more tangible and non-transitory computer-readable media that are configured to store data and/or instructions. The computer-readable storage medium stores instructions, and specifically, stores temporary and permanent copies of the instructions.

The SoC shown in FIG. 19 may be independently disposed in the electronic device. When the SoC is disposed in the electronic device, the static random access memory unit 530 stores instructions, and the instructions may include instructions that, when executed by at least one of the processors, cause the electronic device to implement the methods shown in FIG. 4a, FIG. 5b, FIG. 8, FIG. 9, FIG. 12a, and FIG. 14.

The term "and/or" in this specification describes only an association relationship for describing associated objects and indicates that three relationships may exist. For example, A and/or B may indicate the following three cases: Only A exists, both A and B exist, and only B exists.

All method implementations of this application may be implemented by software, a magnetic component, firmware, or the like.

Program code may be used to input instructions, to perform functions described in this specification and generate output information. The output information may be applied to one or more output devices in a known manner. For a purpose of this application, a processing system includes any system having a processor such as a digital signal processor (Digital Signal Processor, DSP), a microcontroller, an application-specific integrated circuit (ASIC), or a microprocessor.

The program code may be implemented in a high-level procedural language or an object-oriented programming language, to communicate with the processing system. The program code may alternatively be implemented by using an assembly language or a machine language when needed. Actually, the mechanism described in this specification is not limited to a scope of any particular programming language. In any case, the language may be a compiled language or an interpretive language.

One or more aspects of at least one embodiment may be implemented by using representative instructions stored on a computer-readable storage medium. The instructions represent various logic in a processor, and when the instructions are read by a machine, the machine acts on the logic for performing the technologies described in this specification. These representations, referred to as "intellectual property (Intellectual Property, IP) cores", may be stored on a tangible computer-readable storage medium and provided to a plurality of customers or production facilities to be loaded into a manufacturing machine that actually manufactures the logic or processor.

In some cases, an instruction converter may be configured to convert instructions from a source instruction set to a target instruction set. For example, the instruction converter may convert, in a manner of transform (for example, a static binary transform, or a dynamic binary transform including dynamic compilation), morphing, or emulation, or another manner, the instructions into one or more other instructions processed by a core. The instruction converter may be implemented by software, hardware, firmware, or a combination thereof. The instruction converter may be located on the processor, outside the processor, or partially on the processor and partially outside the processor.

## Claims

1. An audio output method, applied to an electronic device, wherein the method comprises:
receiving audio output requests from M audio applications on the electronic device; and
selecting N target applications from the M audio applications, and outputting audio data of the N target applications, wherein M is greater than N.

2. The method according to claim 1, wherein N is a positive integer greater than 2.

3. The method according to claim 1 or 2, wherein the selecting N target applications from the M audio applications comprises:
selecting the N target applications from the M audio applications based on a current working scenario of the electronic device;
selecting the N target applications from the M audio applications based on preset application priority information; or
selecting the N target applications from the M audio applications based on a selection operation performed by a user on the M audio applications.

4. The method according to claim 3, wherein the selecting the N target applications from the M audio applications based on a current working scenario of the electronic device comprises:
determining the current working scenario of the electronic device;
determining a scenario-based application from the M audio applications based on the current working scenario, wherein the scenario-based application is an application required in the current working scenario; and
determining the N target applications based on a determining result of the scenario-based application, wherein the N target applications comprise at least the scenario-based application.

5. The method according to claim 4, wherein the determining the N target applications based on a determining result of the scenario-based application comprises:
determining a priority of each of the M audio applications based on a determining result of the scenario-based application, wherein a priority of the scenario-based application is higher than a priority of another application in the M audio applications; and
determining N audio applications with highest priorities as the N target applications based on an order of priorities of the M audio applications, so that the N target applications comprise at least the scenario-based application.

6. The method according to claim 4, wherein the determining the current working scenario of the electronic device comprises:
determining the current working scenario based on another electronic device that is communicatively connected to the electronic device;
determining the current working scenario based on an application currently running on the electronic device;
determining the current working scenario based on measurement data of a specific sensor on the electronic device, wherein the specific sensor is configured to measure a displacement, a speed, and/or acceleration data of the electronic device; or
determining the current working scenario based on a scenario specifying operation of the user.

7. The method according to any one of claims 3 to 6, wherein the current working scenario of the electronic device comprises an in-vehicle scenario, a home scenario, a conference scenario, a motion scenario, or a high-speed rail travel scenario.

8. The method according to any one of claims 1 to 7, wherein the electronic device comprises a plurality of pieces of volume control information corresponding to the N target applications, and each of the N target applications corresponds to one of the plurality of pieces of volume control information; and
the outputting audio data of the N target applications comprises:
determining volume of the target application based on volume control information corresponding to the target application; and
outputting audio data of the target application at the volume.

9. The method according to claim 8, wherein the electronic device comprises N pieces of volume control information, and the N target applications are in a one-to-one correspondence with the N pieces of volume control information.

10. The method according to claim 8, wherein the electronic device comprises a plurality of pieces of volume control information corresponding to the N target applications, and each of the plurality of pieces of volume control information can be determined based on a user input.

11. The method according to any one of claims 1 to 10, wherein the outputting audio data of the N target applications comprises:
playing the audio data of the N target applications through a plurality of audio playback devices, wherein the audio playback devices comprise the electronic device and/or a device other than the electronic device.

12. The method according to claim 11, wherein the playing the audio data of the N target applications through a plurality of audio playback devices comprises:
determining an audio playback device corresponding to each of the N target applications, and playing the audio data of the N target applications based on a determining result of the audio playback device; and
the determining an audio playback device corresponding to each of the N target applications comprises:
determining, based on preset device priority information, an audio playback device corresponding to the target application; or
determining, based on a quantity of times the target application is played on each of the audio playback devices, an audio playback device corresponding to the target application.

13. The method according to any one of claims 1 to 12, wherein the M audio applications are applications other than a system phone application.

14. The method according to any one of claims 1 to 13, wherein N is determined by the electronic device based on a quantity of audio playback devices that are currently communicatively connected to the electronic device.

15. A media file recording method, applied to an electronic device, comprising:
receiving a first input when the electronic device outputs audio data of a plurality of audio applications, wherein the first input is used to select one or more target applications from the plurality of audio applications; and
recording a first media file, wherein the recording a first media file comprises: recording audio data of the one or more target applications, to generate the first media file.

16. The method according to claim 15, wherein a quantity of target applications is less than a quantity of audio applications that currently output audio.

17. The method according to claim 15, wherein when the electronic device outputs the audio data of the plurality of audio applications, the electronic device outputs video data of a first video application; and
the recording a first media file comprises:
recording audio data of the one or more target applications, and recording the video data of the first video application, to generate the first media file.

18. An electronic device, comprising:
a memory, configured to store instructions executed by one or more processors of the electronic device; and
a processor, wherein when the processor executes the instructions in the memory, the electronic device is enabled to perform the audio output method according to any one of claims 1 to 14, or perform the media file recording method according to any one of claims 15 to 17.

19. A computer-readable storage medium, wherein the computer-readable storage medium stores instructions, and when the instructions are executed on a computer, the computer is enabled to perform the audio output method according to any one of claims 1 to 14, or perform the media file recording method according to any one of claims 15 to 17.
